Europäisches Patentamt

(19) European Patent Office

Office européen des brevets

(11) Numéro de publication: **0 005 391**
**B1**

(12) **FASCICULE DE BREVET EUROPEEN**

(45) Date de publication du fascicule de brevet: **01.04.81**

(51) Int. Cl.³: **H 04 N 3/18**

(21) Numéro de dépôt: **79400257.6**

(22) Date de dépôt: **23.04.79**

(54) Dispositif d'alimentation régulée d'un circuit de balayage-ligne d'un récepteur de télévision.

(30) Priorité: **02.05.78 FR 7812904**
**02.03.79 FR 7905504**

(43) Date de publication de la demande:
**14.11.79 Bulletin 79/23**

(45) Mention de la délivrance du brevet:
**01.04.81 Bulletin 81/13**

(84) Etats Contractants Désignés:
**BE DE FR GB IT NL SE**

(56) Documents cités:
**SIEMENS BAUTEILE REPORT, vol. 12, n° 4, 1974 MÜNCHEN (DE)**
**PERUTH UND SCHRENK "Praktische Pumptransistorschaltungen für Fernsehempfänger" pages 96 à 98**

(73) Titulaire: **"THOMSON-BRANDT"**
**173, bld Haussmann**
**F-75360 Paris Cedex 08 (FR)**

(72) Inventeur: **Rilly, Gérard**
**THOMSON-CSF-SCPI 173, bld Haussmann**
**F-75360 Paris Cedex 08 (FR)**
Inventeur: **Facon, Michel**
**THOMSON-CSF - SCPI 173, bld Haussmann**
**F-75360 Paris Cedex 08 (FR)**

(74) Mandataire: **Schmolka, Robert et al,**
**"THOMSON-CSF" - SCPI 173. bld Haussmann**
**F-75360 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Dispositif d'alimentation régulée d'un circuit de balayage-ligne d'un récepteur de télévision

La présente invention concerne un dispositif d'alimentation régulée, combiné à l'étage de sortie d'un circuit de balayage-ligne d'un récepteur de télévision, pouvant également fournir des tensions continues d'alimentation à d'autres circuits de celui-ci, en découpant une tension d'alimentation continue obtenue généralement par le redressement et le filtrage de la tension du secteur alternatif à l'aide d'un circuit de découpage.

Des convertisseurs à découpage connus de ce type comportent, généralement connectés en série entre les bornes de sortie d'une source d'alimentation continue (redresseur filtré), un interrupteur électronique tel qu'un transistor de commutation travaillant dans le mode saturé et bloqué, et une inductance comprenant l'enroulement primaire d'un transformateur dont au moins un enroulement secondaire fournit l'énergie alternative obtenue par le découpage, qui est ensuite redressée pour fournir des tensions continues d'alimentation avec une masse isolée du secteur. Dans la plupart des alimentations à découpage connues, on peut faire varier les tensions de sortie en agissant sur le rapport cyclique, c'est-à-dire sur la durée de l'état saturé (fermé) de l'interrupteur, par exemple, en commandant périodiquement le transistor-hâcheur à l'aide d'un basculeur monostable de durée variable en fonction d'une tension qui peut être prélevée à la sortie d'un redresseur alimenté par un autre enroulement secondaire du transformateur de façon à former une boucle de régulation.

Des alimentations à découpage ont fréquemment été utilisées dans des récepteurs de télévision pour éliminer le transformateur d'alimentation secteur, volumineux et pesant et pour permettre une régulation de la tension d'alimentation de celui-ci. Elles ont souvent été combinées notamment à l'étage de sortie du circuit de balayage horizontal qui leur fournit un signal impulsionnel à la fréquence de ligne, utilisable pour commander le découpage. Divers combinaisons de circuits de balayage et d'alimentations à découpage ont été décrits, par exemple dans les publications FR—A—2.040.217, 2.060.495, 2.167.549, 2.232.147 ou 2.269.257, où la régulation est également effectuée à l'aide de la variation du rapport cyclique des états saturé et bloqué du transistor de découpage ou hâcheur qui dans quelques cas est également utilisé comme l'élément actif de l'étage de sortie (final) du circuit de balayage-ligne ou de l'étage d'attaque commandant celui-ci.

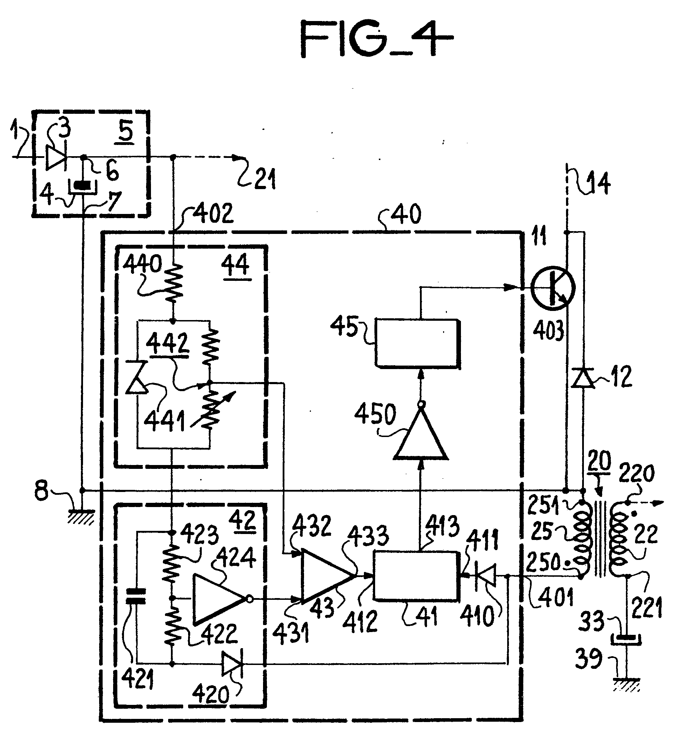

Des alimentations à découpage de type dit "pompe", où le transistor de découpage débite dans l'un des enroulements du transformateur ligne pendant les périodes de retour-ligne et où la régulation est efectuée à l'aide de la variation de la résistance interne de ce transistor ou d'un transistor "ballast" en série avec celui-ci, sont connus par exemple des publications FR—A—2.014.820, 2.025.365 ou 2.116.335. Un circuit de type "pompe" dont le transistor de découpage comporte un enroulement du transformateur-ligne dans son circuit collecteur et où le circuit de balayage est galvaniquement isolé du réseau, a été décrit dans l'article de Peruth et Schrenk de la revue allemande SIEMENS BAUTEILE REPORT Vol. 12 (1974), n° 4, page 96—98. Dans le circuit de la figure 4 de cet article, on a inséré, entre le collecteur du transistor de découpage et l'enroulement du transformateur, une inductance de 100 microhenry en parallèle avec une résistance, qui constituent ensemble un circuit de protection contre des taux de montée excessifs du courant collecteur de ce transistor. La régulation y est effectuée par la variation de la largeur des impulsions commandant celui-ci.

Dans un autre dispositif connu d'alimentation à découpage et de balayage-ligne combinés, décrit dans les publications US—A—3.999.102 ou FR—A—2.272.092 (modes de réalisation des figures 6 et 14 correspondant au préambule de la revendication 1), le circuit de découpage comporte un premier interrupteur bidirectionnel commandé, branché en série avec une première inductance, dite de découpage, entre les bornes d'une source de tension continue avec un condensateur d'accord connecté en parallèle avec cette inductance (ou cet interrupteur) pour former avec celle-ci un premier circuit résonnant dont la fréquence d'oscillation est sensiblement inférieure à celle d'un second circuit résonnant comprenant notamment les bobines de déviation ligne et le condensateur de retour connecté en parallèle avec un second interrupteur bidirectionnel commandé de l'étage de sortie du balayage-ligne, qui est déterminée par la durée de l'intervalle de retour-ligne. Ces bobines en série avec un condensateur d'aller ou d'effet "S" qui les alimente pendant l'aller du balayage et une seconde inductance constituée par un premier enroulement du transformateur-ligne en série avec un condensateur réservoir, sont respectivement connectés en parallèle avec le second interrupteur (qui est généralement commandé par un oscillateur de ligne asservi en fréquence et phase aux impulsions de synchronisation-ligne contenues dans le signal vidéo-complexe). Les interrupteurs de balayage et de découpage sont commandés par des impulsions récurrentes ayant la même fréquence de répétition.

Dans les modes de réalisation précités (des figures 6 et 14), l'inductance de découpage est magnétiquement couplée au premier enroulement du transformateur-ligne du fait qu'il en constitue un second enroulement, dit d'alimentation, de sorte que le transfert d'énergie entre les circuits de découpage et de balayage s'effectue par l'intermédiaire de ce transformateur. Lorsque le couplage entre les premier et second enroulements est lâche, les fréquences de résonance des circuits oscillants formés respectivement par l'inductance de découpage et le condensateur d'accord, et par les inductances des bobines de déviation et du premier enroulement du transformateur en parallèle avec le condensateur de retour, peuvent être très différentes et les instants de blocage récurrents des interrupteurs de balayage et de découpage suivis chacun d'une demi-période d'oscillation de ces circuits oscillants peuvent être déphasés l'un par rapport â l'autre. La variation de ce déphasage relatif ou de cet intervalle de retard donne lieu à une variation de la puissance fournie et, par conséquent, de la tension aux bornes du condensateur réservoir. Ce fait est utilisé pour la régulation de cette tension de réservoir alimentant, notamment, l'étage de sortie et dont dépend, d'une part, l'amplitude crête-à-crête de la forme d'onde du courant de balayage-ligne en dent de scie et, d'autre part, la très haute tension alimentant le tube à rayons cathodiques.

Lorsque le retard de phase entre les instants de blocage des interrupteurs de balayage et de découpage est tel que les maxima respectifs des tensions d'oscillation en forme de demi-sinusoïdes des deux circuits oscillants sont décalés sensiblement d'une demi-période de récurrence, c'est-à-dire lorsque les maxima de tension des oscillations provoquées aux bornes de l'un des circuits résonnants par l'ouverture de l'interrupteur associé coïncident avec les passages par zéro du courant dans l'inductance de l'autre circuit résonnant qui est alors réunie en parallèle à sa source de tension d'alimentation (ou réservoir) continue associée, le transfert d'énergie entre les deux circuits est nul.

Pour des sens relatifs prédéterminés des deux enroulements précités du transformateur-ligne, le transfert d'énergie augmente dans un sens, lorsque l'écart de phase devient inférieur à celui correspondant à un transfert nul, et dans l'autre sens, lorsqu'il devient supérieur. Ceci implique, d'une part, que l'inversion du sens de l'un de ces enroulements permet d'inverser le sens du transfert d'énergie et, par conséquent, celui de la variation du retard de phase et, d'autre part, que le circuit est reversible de sorte que si l'on réunit les bornes du condensateur réservoir à celles d'une source de tension continue, le circuit de balayage peut fournir de l'énergie de façon régulée au circuit de découpage, si l'on remplace sa source d'alimentation par un condensateur de filtrage connecté à une charge en parallèle.

De ce qui précède, il résulte que pour obtenir une régulation de la tension aux bornes du condensateur réservoir, il faut commander l'ouverture de l'interrupteur de découpage avec un retard par rapport à celle de l'interrupteur de balayage, qui est variable en fonction de cette tension de réservoir ou d'une tension fonction de celle-ci telle que l'une des amplitudes de l'impulsion de retour-ligne. On dispose de nombreux circuits connus permettant de faire varier le retard d'une impulsion on d'une transition (front avant ou arrière) de sortie par rapport à une impulsion ou transition d'entrée en fonction d'une tension continue, appelés générateurs de retard, tels que notamment des basculeurs monostables du type à amplificateur différentiel à couplage par émetteurs dont une tension de polarisation de la base ou du collecteur varie, ou un générateur de dents de scie déclenché par la forme d'onde d'entrée et alimentant un comparateur de tension, où soit la tension de seuil du comparateur, soit la pente de la dent de scie est modifiée en fonction d'une tension dérivée de la tension de réservoir.

Dans le dispositif d'alimentation à découpage suivant le préambule, l'inductance de découpage n'est plus constituée par le seul second enroulement du transformateur-ligne, mais comprend une inductance (bobine de choc) en série avec ce second enroulement appelé "d'alimentation".

Selon l'invention, la valeur de cette bobine (de plusieurs millihenry) est choisie de façon à rendre celle de l'inductance de découpage qui est composée de l'inductance de fuite de l'enroulement d'alimentation et de celle de la bobine en série, sensiblement égale ou supérieure au triple de celle des bobines de déviation ramenée dans le circuit de l'enroulement d'alimentation par le transformateur-ligne. Cette bobine fait partie intégrante de l'inductance de découpage et, de ce fait, du circuit résonnant comprenant le condensateur d'accord.

L'inductance ramenée par le transformateur-ligne dans le circuit de découpage est sensiblement égale à l'inductance des bobines de déviation-ligne multipliée par le carré du rapport de transformation entre les premier et second enroulements de ce transformateur.

La mesure selon l'invention permet une bonne séparation relative entre les circuits de découpages et de balayage.

Le transistor de découpage y est commandé par un circuit de régulation alimenté par des impulsions de retour-ligne provenant d'un enroulement auxiliaire du transformateur-ligne, qui déclenche un générateur de retard variable et dont une amplitude crête redressée commande la variation de ce retard.

Suivant un mode de réalisation préféré de l'invention, le second interrupteur bidirectionnel comprenant le transistor de découpage qui est commandé sur sa base à l'aide d'un circuit de régulation perfectionné, alimenté par la tension du réseau redressée et stabilisée et qui comporte un multivibrateur astable fonctionnant au démarrage de façon autonome afin de permettre l'alimentation du circuit de balayage-ligne tout entier à partir du condensateur d'alimentation ou réservoir qui est chargé par un courant dû au courant de découpage induit dans le premier enroulement du transformateur-ligne et redressé par la diode en anti-parallèle avec le transistor de balayage. Dès la mise en route de l'oscillateur-ligne alimenté par la tension réservoir, l'étage de sortie-ligne fournit sur l'enroulement auxiliaire du transformateur-ligne des impulsions retour-ligne qui déclenchent le générateur de retard variable et dont l'amplitude redressée fournit une tension de régulation à ce générateur. Ces impulsions peuvent également assurer la synchronisation du multivibrateur préalablement à la régulation par variation du déphasage.

L'invention sera mieux comprise et d'autres de ses caractéristiques et avantages ressortiront de la description qui suit, donnée à titre d'exemple, et des dessins annexés s'y rapportant, sur lesquels:

— la figure 1 représente un schéma de principe partiel d'un dispositif d'alimentation à découpage combiné à l'étage de sortie du circuit de balayage-ligne, conformément à l'invention;

— les figures 2 et 3 sont des digrammes des formes d'onde de tension et/ou de courants à divers points du circuit de la figure 1 pour expliquer le fonctionnement de celui-ci;

— la figure 4 représente le schéma partiellement synoptique d'un mode de réalisation simple (sans dispositif de démarrage) de circuit de régulation 40 de la figure 1;

— la figure 5 représente un bloc-diagramme d'un mode de réalisation préféré du circuit de régulation 40 de la figure 1, suivant l'invention;

— la figure 6 représente un schéma de principe de l'ensemble du mode de réalisation préféré du circuit de régulation de la figure 5;

— la figure 7 représente des formes d'onde de tension illustrant l'asservissement de la fréquence du multivibrateur astable 48 à celle de l'oscillateur-ligne; et

— la figure 8 représente des formes d'onde de tension illustrant le fonctionnement de la régulation par la variation du déphasage.

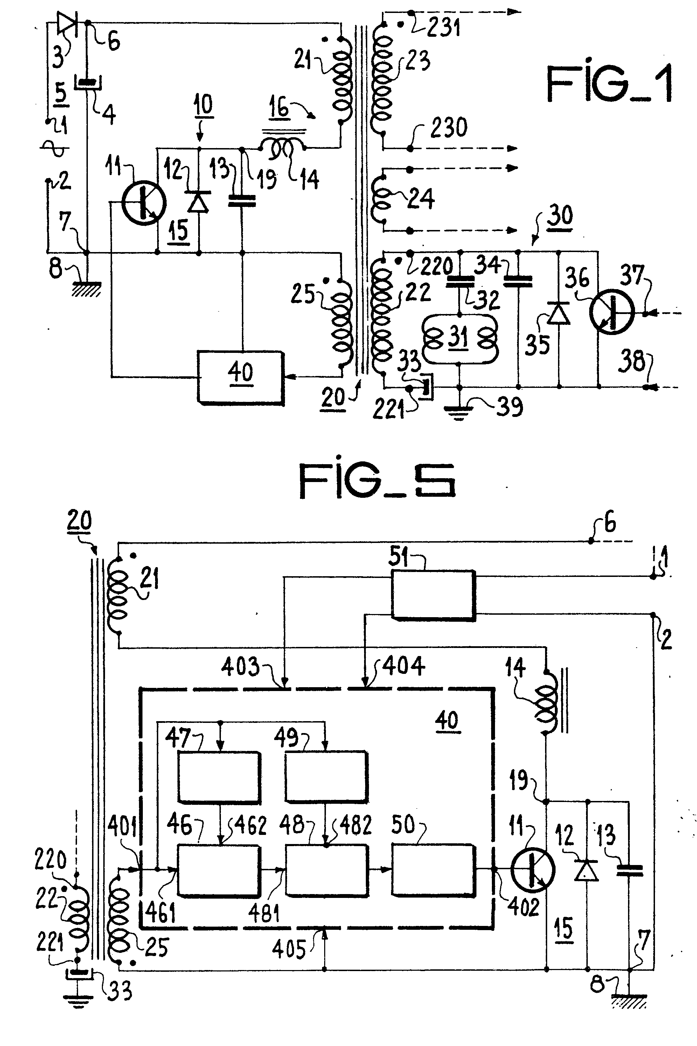

Sur la figure 1, on a représenté schématiquement un dispositif d'alimentation à découpage de l'étage de sortie 30 de balayage-ligne suivant l'invention, présentant un isolement galvanique entre le réseau alternatif qui alimente un redresseur 5 dont la tension de sortie est découpée. Ce dispositif d'alimentation comporte deux bornes 1, 2 respectivement reliées à deux pôles du réseau alternatif de distribution (220 V, 50 Hz) et alimentant une diode de redressement 3 et un condensateur de filtrage 4 de capacité élevée, réunies an série, qui forment ensemble un montage redresseur ou une source de tension continue 5. La sortie du montage redresseur 5 constituée par les deux bornes 6 et 7 (armatures) du condensateur (électro-chimique) 4, est destinée à fournir une tension continue d'alimentation $V_A$ de l'ordre de 300 V environ à un circuit de découpage ou hâcheur 10. Ce circuit de découpage 10 comporte un interrupteur électronique bidirectionnel commandé 15, composé d'un transistor de commutation du type NPN 11, connecté en émetteur commun et d'une diode semiconductrice à jonction 12 qui sont réunis en parallèle de façon à conduire respectivement dans des directions opposées (anti-parallèle), et une inductance de découpage 16 composée d'un enroulement 21 d'un transformateur, dit de ligne 20, et conformément à l'invention, d'une bobine selfique 14, reliés en série. Cet enroulement 21 du transformateur de ligne 20 dont l'enroulement primaire est habituellement connecté en parallèle avec les bobines du déviateur horizontal dans le circuit de l'étage de sortie 30 du balayage-ligne pour fournir par l'intermédiaire d'enroulements secondaires des tensions d'alimentation, notamment au tube à rayons cathodiques, sera appelé dans ce qui suit enroulement d'alimentation, car le transfert d'energie entre le circuit de découpage 10 et l'étage de sortie 30 sera effectué par son intermédiaire. L'interrupteur 15 est monté en parallèle avec un condensateur 13 et il est connecté en série avec l'inductance 16 (bobine 14 et enroulement d'alimentation 21 en série) entre les bornes de sortie 6 et 7 de la source de tension continue 5. Ce condensateur 13 constitue, du fait de sa faible capacité par rapport à celle du condensateur de filtrage 4, avec l'inductance 16, un circuit résonnant (oscillant) parallèle lors de l'ouverture de l'interrupteur électronique 15 par le blocage du transistor de commutation 11 au moyen d'un signal de commande appliqué à sa base. Il est à noter que l'utilisation d'un interrupteur bidirectionnel à commande unidirectionnelles comprenant un transistor de découpage et une diode, montés pour conduire en des sens opposés et connectés en série avec une inductance constituée par l'enroulement d'un transformateur et en parallèle avec un condensateur assurant l'accord de l'inductance lors de l'ouverture de l'interrupteur de découpage est connu de la publication DE—B—1.234.836.

Le transistor interrupteur 11 est réuni ici par son collecteur à l'une des bornes de l'inductance 16 dont l'autre borne est reliée à la borne positive 6 de la source 5 fournissant la tension continue d'alimentation $V_A$, par son émetteur à la borne négative 7 de la source 5 qui constitue une masse, dite primaire ou chaude 8, reliée au réseau alternatif, mais isolée de celle 39 du téléviseur. La base du transistor 11 est commandée à l'aide de signaux rectangulaires fournis par un circuit de régulation 40, décrit plus loin, de façon à être alternativement saturé et bloqué. Le circuit de régulation 40 est, par exemple, alimenté par un enroulement auxiliaire 25 du transformateur 20, fournissant des signaux dont l'amplitude crête-à-crête est proportionnelle à l'amplitude crête de l'impulsion de retour-ligne. Cette amplitude crête est une fonction du transfert d'énergie du circuit de découpage 10 à l'étage de sortie 30 du balayage-ligne qui est réuni à un autre enroulement 22 du transformateur 20.

On remarquera ici, que le circuit de découpage 10 ressemble à un étage de sortie de balayage-ligne transistorisé, classique et que le transistor de commutation 11 est choisi pour supporter des tensions collecteur-émetteur élevées (de l'ordre de 1500 V), la diode 12 devant supporter la même tension inverse durant l'ouverture de l'interrupteur 15. On notera également que l'inductance de la self de choc 14 peut être constituée en partie, suivant l'invention, ou en totalité, selon FR—A—2.275.092, par l'inductance de fuite de l'enroulement d'alimentation 21 de transformateur 20.

L'étage de sortie du balayage-ligne 30 agencé de manière classique, comporte des bobines de déviation horizontale 31 montées en parallèle et reliées par l'une de leur bornes à un premier condensateur 32, dit "d'aller" ou "d'effet S", qui les alimente pendant l'aller du balayage. Le montage série des bobines 31 et du condensateur d'aller 32 est réunie en parallèle, d'une part, avec un second interrupteur bidirectionnel commandé comprenant un second transistor de commutation 36 et une seconde diode 35, dite de récupération "shunt" ou "parallèle", connectés en parallèle pour conduire dans des directions opposées, fermé (conducteur) pendant l'aller et ouvert (bloqué) pendant le retour du balayage, et d'autre part, avec un second condensateur 34, dit de "retour", formant pendant l'ouverture du second interrupteur un circuit résonnant parallèle avec l'inductance des bobines de déviation 31. Le point commun du collecteur du second transistor 36, du type NPN, de la cathode de la seconde diode 35 et des condensateurs de retour 34 et d'aller 32, est relié à l'une des bornes 220 de l'enroulement 22 du transformateur 20, qui constitue habituellement l'enroulement primaire de celui-ci. L'autre borne 221 de l'enroulement 22 est reliée à l'une des bornes d'un troisième condensateur 33 de capacité élevée, dont l'autre borne est reliée au point commun des bobines de déviation 31, du condensateur de retour 34, de l'anode de la seconde diode 35 et de l'émetteur du second transistor 36, qui est également réuni à la masse 39 du châssis du récepteur de télévision, dite masse "froide", car elle est isolée du réseau d'alimentation alternatif. C'est aux bornes de ce troisième condensateur 33 que l'on obtient la tension continue alimentant cet étage, dont la valeur détermine, d'une part, l'amplitude crête-à-crête du courant de balayage-ligne en forme de dents-de-scie et, d'autre part, l'amplitude de l'impulsion de tension de retour-ligne qui, redressée après transformation, fournit la très haute tension polarisant l'anode du tube à rayons cathodiques (non représenté ici). Le second transistor 36, également de commutation, est commandé par des signaux rectangulaires fournis à des bornes d'entrée 37 et 38 de l'étage 30, respectivement reliées à sa base et à son émetteur, par un étage d'attaque (non représenté et appelé "driver" dans la littérature anglo-américaine) de façon à le rendre alternativement bloqué, pendant le retour du balayage, et saturé, pendant la seconde partie de l'aller du balayage.

Dans les circuits de balayage-ligne classiques à transistor, une source de tension continue alimente généralement soit directement la borne 221 de l'enroulement 22, soit une prise intermédiaire de celui-ci à travers une diode (voir publications FR—A—1.298.087, 1.316.732, ou 1.361.201) qui isole l'enroulement primaire du transformateur de ligne de la source d'alimentation continue pendant l'intervalle de retour-ligne.

Dans le circuit de la figure 1, c'est l'énergie électrique alternative transmise par le circuit de découpage 10 à travers les enroulements 21 et 22 du transformateur 20 qui charge le condensateur 33 pour qu'il fournisse une tension d'alimentation régulée à l'étage de sortie 30. Pendant les périodes de l'aller du balayage-ligne, lorsque le second interrupteur bidirectionnel 35, 36 de l'étage de sortie du balayage 30 est fermé (conducteur), les bornes de l'enroulement 22 du transformateur 20 sont directement réunies à celles du condensateur 33 qui recevra donc l'énergie fournie par le circuit de découpage 10.

Sur la figure 1, le transformateur de ligne 20 comporte, en outre, un enroulement très haute tension 23 dont une borne 230 peut être réunie à la masse 39 (ou à la borne 220 de l'enroulement 22) et dont l'autre borne 231 est réunie à l'entrée du montage redresseur très-haute-tension ou du multiplicateur de tension (non représentés) de manière classique, et un enroulement auxiliaire 24 qui peut être utilisé pour alimenter soit un montage redresseur basse-tension, soit un montage régulateur de charge, soit le filament du tube à rayons cathodiques (non représentés). Ces enroulements secondaires 23, 24 recevront leur énergie principalement de l'étage de sortie 30 du circuit de balayage-ligne à travers l'enroulement 22 du transformateur 20, c'est-à-dire les impulsions de retour-ligne, le couplage entre les enroulements 22, 23 et 24 sera donc aussi serré que possible.

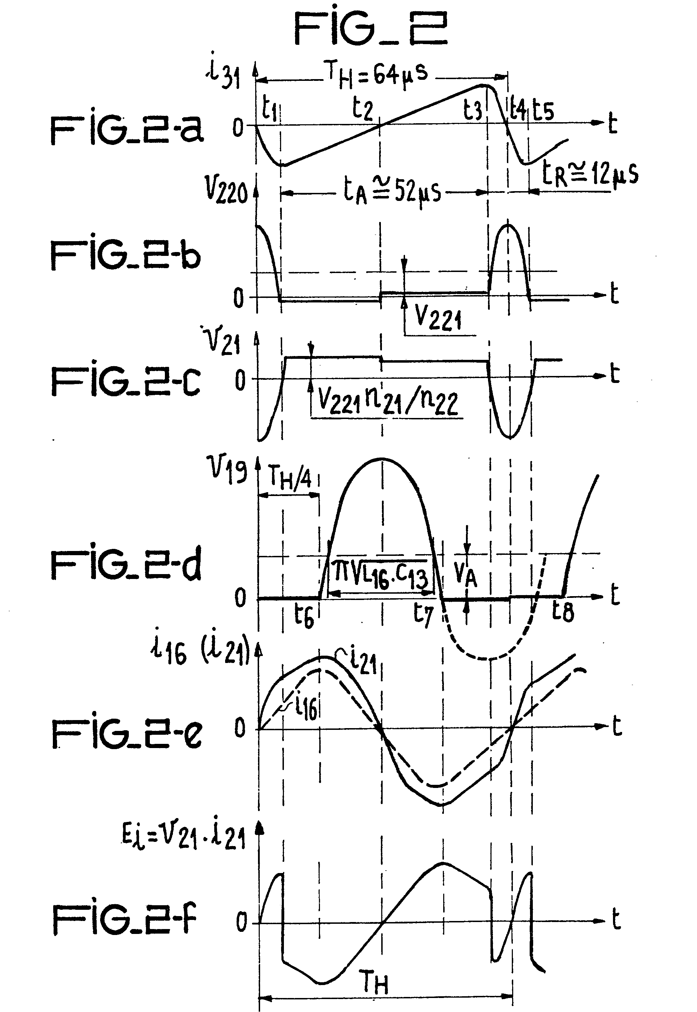

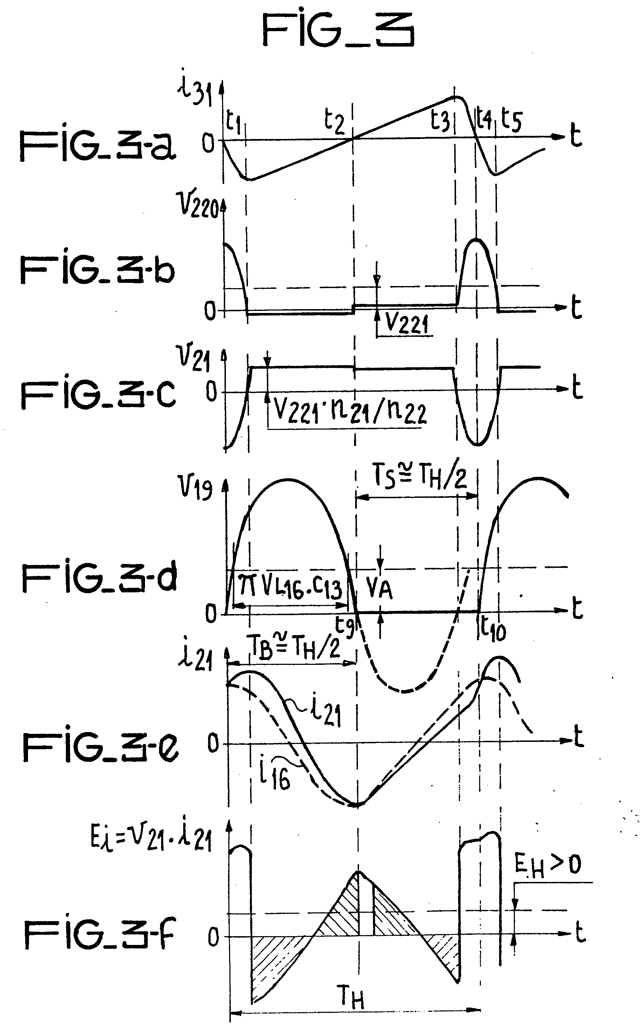

Le fonctionnement du dispositif d'alimentation de la figure 1 sera expliqué ci-dessous avec celui de l'étage de sortie 30 du circuit de balayage-ligne, avec référence aux figures 2 et 3 du dessin annexé, représentant des diagrammes de formes d'onde de tensions et/ou de courants à divers points du schéma de la figure 1.

Sur les figures 2 et 3, le diagramme (A) représente la forme d'onde en dents-de-scie du courant de balayage $i_{31}(t)$ dans les bobines 31 du déviateur horizontal. Le diagramme (B) représente la forme d'onde de la tension $v_{220}(t)$ sur la borne 220 de l'enroulement 22, qui est également celle aux bornes du second interrupteur 35, 36. Le diagramme (C) est la forme d'onde de la tension $v_{21}(t)$ aux bornes de l'enroulement d'alimentation 21 lorsque son inductance de fuite est négligeable, elle est obtenue par la transformation de la composante alternative de la tension $v_{220}(t)$. Le diagramme (D) représente la forme d'onde de la tension $v_{19}(t)$ aux bornes du premier interrupteur 15 du circuit de découpage 10, c'est-à-dire entre la jonction 19 de celui-ci avec l'inductance 16 et la masse primaire 8, et le diagramme (E) représente en pointillé le courant $i_{16}(t)$ dans l'inductance 16, lorsque l'étage de sortie 30 n'est pas commandé et en trait plein le courant $i_{21}(t)$ résultant de la superposition dans l'enroulement 21 du courant $i_{16}(t)$ à celui induit par l'enroulement 22, lorsque l'étage de sortie 30 est en marche. Inversement, le courant dans l'enroulement 22 du transformateur 20 résulte de la superposition du courant induit par l'enroulement 21 au courant produit par la fermeture du second interrupteur 35, 36, analogue à $i_{31}(t)$ du diagramme (A).

Les formes d'onde des diagrammes (D) et (E) des figures 2 et 3, sont respectivement déphasées, les unes par rapport aux autres, d'un quart de période de ligne $T_H/4$ pour permettre l'illustration de la régulation par la variation de la phase relative des ondes de tension $v_{21}$ et de courant $i_{21}$ dans l'enroulement d'alimentation 21.

Les diagrammes (F) représentent l'énergie instantanée $E_i$ transmise par le circuit de découpage 10 à l'étage de sortie 30, qui est égale au produit des formes d'onde de courant $i_{21}(t)$ et de tension $v_{21}(t)$ de l'enroulement 21, c'est-à-dire $E_i = -v_{21}.i_{21}$, pour deux écarts de phase différents entre les ondes de tension $v_{21}(t)$ et de courant $i_{21}(t)$ de l'enroulement d'alimentation 21, correspondant respectivement à un transfert d'énergie nul, sur la figure 2, et maximal, sur la figure 3.

Le fonctionnement de l'étage de sortie 30 du balayage-ligne est classique dès que les condensateurs d'alimentation 33 et d'aller 32 sont chargés à une tension continue $V_{221}$ à l'aide d'un certain nombre de cycles de découpage, autonomes au démarrage, durant lesquels les alternances négatives de l'onde de tension découpée sont redressées par la diode de récupération 35.

Durant les intervalles de l'aller $t_A$ du balayage, où l'interrupteur 35, 36 est fermé de l'instant $t_1$ à l'instant $t_3$, le courant $i_{31}$ (voir A) du déviateur varie sensiblement linéairement entre ses valeurs de crête négative (à $t_1$) et positive (à $t_3$) avec un passage par zéro à l'instant $t_2$, lorsque le courant $i_{31}$ passe de la diode 35 au transistor 36 préalablement polarisé pour conduire. Ceci correspond à une tension $v_{220}$ sensiblement nulle (voir B) aux bornes de l'interrupteur 35, 36.

L'intervalle de retour-ligne $t_R$ est amorcé par le blocage du transistor 36 à l'instant $t_3$, et l'inductance du déviateur 31 se comporte alors comme un circuit résonnant parallèle avec le condensateur de retour 34 en faisant parcourir à la tension $v_{220}(t)$ une demi-sinusoïde positive atteignant sa valeur crête à l'instant $t_4$ (ou $t = 0$), dite impulsion de retour-ligne, et au courant $i_{31}(t)$ une demi-cosinusoïde entre les valeurs de crête positive et négative précitées, avec passage par zéro à l'instant $t_4$ (ou $t = 0$). La valeur moyenne de la forme d'onde de tension $v_{220}(t)$ à la borne 220 est égale à la tension d'alimentation continue $V_{221}$ aux bornes des condensateurs d'alimentation 33 et d'aller ou d'effet S 32.

Les amplitudes crête-à-crête respectives du courant $i_{31}(t)$ (donc la largeur de l'excursion du faisceau balayant l'écran) et de la tension $v_{220}(t)$ (donc la T.H.T.) dépendent de la valeur de la tension continue $V_{221}$ qui alimente l'étage de sortie du balayage horizontal 30 et qui dans la plupart des alimentations à découpage de la technique antérieure, est régulée et stabilisée en modulant la durée de l'état saturé (le rapport cyclique) du transistor de découpage 11 en fonction de l'amplitude de l'impulsion de retour-ligne prélevée sur un enroulement auxiliaire du transformateur de ligne 20 (donc de la tension aux bornes du condensateur 33) et éventuellement de la tension du réseau redressée et filtrée.

Dans le cas présent, la durée $t_s$ de l'état saturé du transistor de découpage 11 et de l'état conducteur de la diode 12 et, par conséquent, le rapport de cette durée à celle du cycle entier (période de ligne $T_H$) ou à celle $t_B$ de l'état bloqué, sont constants et choisis de façon à rendre l'amplitude crête de l'impulsion de tension $v_{19}$, appliquée au collecteur du transistor 11 pendant l'intervalle de blocage $t_B$, notablement inférieure à sa tension continue de claquage collecteur-émetteur à l'état bloqué ($V_{CEX}$) qui peut actuellement dépasser 1500 Volts. Ainsi, pour une tension redressée de 300V, il est possible de limiter la tension collecteur $V_{19}$ à 900 volts environ en choisissant un rapport $t_B/T_H$ d'environ 0,5.

Par conséquent, le circuit de découpage ou hâcheur 10 doit fonctionner à la fréquence de ligne avec les durées de conduction $t_S$ (fermeture) et de blocage $t_B$ (ouverture), de l'interrupteur 15, de préférence, sensiblement égales (à une demi-période de ligne $T_H/2$) et la régulation de l'énergie fournie à l'étage de sortie 30 est effectuée en faisant varier les phases respectives de l'impulsion de retour-ligne $V_{220}(t)$ et du courant $i_{21}(t)$ parcourant l'enroulement d'alimentation 21 du transformateur 20, comme il sera démontré plus loin.

Le fonctionnement du circuit de découpage 10 (alimenté par la tension continue $V_A$) est en effet analogue à celui de l'étage de sortie 30, sauf en ce qui concerne le facteur de forme qui est déterminé principalement par les valeurs respectives de l'inductance 16 (de la self de choc 14 et de l'inductance de fuite de l'enroulement 21 du transformateur 20 connectés en série) et de la capacité du condensateur d'accord 13. Les valeurs $L_{16}$ et $C_{13}$ sont choisies de façon à obtenir une demi-période d'oscillation légèrement inférieure à une demi-période de ligne, c'est-à-dire:

$$T_D = 2\pi\sqrt{L_{16}.C_{13}} = 2\pi\sqrt{(L_{14} + L_{21}).C_{13}} < T_H,$$

car l'oscillation du circuit résonant $L_{16}$, $C_{13}$ se produit de part et d'autre de la tension continue $V_A$, de sorte que la période blocage de l'interrupteur de découpage 15 est supérieure à cette demi-période $T_D/2$.

Ce fonctionnement du circuit 10 sera d'abord expliqué avec référence aux diagrammes D et E de la figure 2. Lorsque, à l'instant $t = 0$, le transistor 11 devient saturé par une polarisation positive préalable de sa jonction base-émetteur, il réunit la borne 19 à la masse 8, de sorte qu'un courant $i_{16}(t)$ (en pointillé sur le diagramme E) croissant linéairement

$$(i_L = \frac{1}{L} \int_o^{t6} v_L . dt = \frac{V_A}{L_{16}} \int_o^{t6} dt)$$

parcourt l'inductance 16 en provenance de la borne 6 positive de l'alimentation 5.

Lorsque le transistor 11 reçoit du circuit de régulation 40 une tension de blocage à un instant précédant l'instant $t_6$ du temps de stockage des porteurs de charge minoritaires, l'interrupteur 15 s'ouvre et le courant emmagasiné dans l'inductance 16, $i_{16}(t_6) = V_A t_6/L = V_A.T_H/4L$, s'écoulera à travers le condensateur d'accord 13 de manière oscillatoire, c'est-à-dire cosinusoïdale, en décroissant vers une valeur nulle, tandis que la tension $V_{19}$ à la jonction 19 de l'inductance 16 et du condensateur 13 croîtra sinusoïdalement vers une valeur maximale, ces deux valeurs coïncidant dans le temps. Ensuite, le condensateur 13 se décharge à travers l'inductance 16 également de manière oscillatoire jusqu'à ce que, à l'instant $t_7$, la tension $v_{19}$ atteigne une valeur nulle correspondant à une valeur minimale, c'est-à-dire maximale négative, du courant $i_{16}(t)$ dont la valeur absolue est légèrement inférieure à la valeur maximale positive $i_{16}(t_6)$. La différence entre les valeurs crêtes $i_{16}(t_6)$ et $i_{16}(t_7)$ en absolue s'explique, d'une part, par les pertes ohmiques dans le circuit 10 et, d'autre part, par le transfert d'énergie entre celui-ci et, principalement, l'étage de sortie 30.

Lorsque la tension oscillatoire $v_{19}(t)$ a dépassé légèrement la valeur nulle vers des valeurs négatives, la diode 12 se met à conduire de façon à réunir la borne 19 à la masse et d'engendrer dans l'inductance 16 un courant $i_{16}(t)$ croissant linéairement de sa valeur negative maximale $i_{16}(t_7)$ vers une valeur nulle où le transistor 11, préalablement polarisé pour être saturé, le reprend pour qu'il atteigne, à l'instant $t_8$, de nouveau sa valeur maximale positive de l'instant $t_6$.

Il est à remarquer ici, que la valeur moyenne de la forme d'onde de tension $v_{19}$ à la borne 19 est égale à la tension continue d'alimentation $V_A$ entre les bornes 6 et 7 du condensateur de filtrage 4 du montage redresseur 5.

Suivant l'invention, pour assurer un transfert d'énergie et une séparation adéquates entre le circuit de découpage 10 et l'étage de sortie 30 de balayage-ligne, il est avantageux de choisir la valeur de l'inductance 16 en série avec l'enroulement d'alimentation 21, c'est-à-dire la somme de l'inductance de fuite de cet enroulement et de celle de la bobine ou self de choc série 14, de façon à être, par exemple, supérieure ou égale au triple de l'inductance $L_{31}$ des bobines du déviateur horizontal 31 ramenée du côté de cet enroulement 21, c'est-à-dire multipliée par le carré du rapport de transformation entre les enroulements 22 et 21, c'est-à-dire $L_{16} \geqslant 3L_3 (n_{22}/n_{21})^2$, et la valeur de ce rapport de transformation $n_{22}/n_{21}$ de façon à obtenir aux bornes de l'enroulement 21, pendant l'aller du balayage et la fermeture de l'interrupteur 15, une tension induite $v_{21}(t)$ d'amplitude comprise entre 100 et 150 volts, c'est-à-dire, entre le tiers et la moitié de la tension d'alimentation $V_A$ aux bornes 6, 7 du condensateur de filtrage 4.

Comme la tension continue $V_{221}$ aux bornes du condensateur 33 est fonction de l'inductance $L_{31}$ des bobines de déviation horizontale 31 et, de ce fait, comprise entre 50 et 140 volts environ, le rapport de transformation $n_{22}/n_{21}$, c'est-à-dire entre les nombres de spires $n_{22}$ et $n_{21}$ respectifs des enroulements 22 et 21, est compris entre 1 et 4 environ (de préférence entre 2 et 3).

Le choix de ces paramètres n'est indiqué ici qu'à titre d'exemple, car le critère de ce choix est une bonne séparation entre le circuit de découpage 10 et notamment, le circuit 30 qu'il alimente, c'est-à-dire que le courant $i_{21}(t)$ dans l'enroulement 21 ne soit induit dans l'enroulement 22 qu'avec des amplitudes-crête ne dépassant pas le tiers environ de celles du circuit de balayage 30 pendant la conduction de la diode de récupération 35. En outre, les impulsions de tension $v_{19}(t)$ des diagrammes (D) des figures 2 et 3 ne devraient se présenter aux bornes de l'enroulement 21 et ne devraient être transmises à l'enroulement 22, au moins pendant l'ouverture de l'interrupteur 36, 35 de balayage (intervalle de retour-ligne), à l'enroulement 22, qu'avec des amplitudes assez faibles pour ne pas perturber le fonctionnement de l'étage de sortie 30 et du redresseur T.H.T. alimenté par l'enroulement 23, tout en conservant un transfert d'énergie suffisant pour obtenir une tension d'alimentation régulée à sa valeur désirée.

Le transformateur 20 peut donc être réalisé de manière à présenter un couplage peu serré entre les enroulements 21 et 22, l'inductance "selfique" est alors composé de celle ($L_{14}$) la bobine de choc 14 et de l'inductance de fuite

$(L_{21})$ propre à l'enroulement 21. Il est donc avantageux, lorsque l'on utilise un noyau (circuit magnétique) en ferrite de forme rectangulaire (en forme de cadre), de placer les enroulements 22, 23 et 24 sur l'une des jambes de celui-ci, et l'enroulement 21 et, éventuellement l'enroulement 25, sur l'autre, ce qui concourt également à un bon isolement entre les masses primaire 8 et secondaire 39. La dimension de l'entrefer du circuit magnétique du transformateur 20 ou un shunt magnétique déterminant l'inductance de fuite $L_{21}$, ainsi que l'inductance $L_{14}$ de la self de choc 14, sont donc choisies en vue de ce résultat.

On peut donc considérer que, du point de vue du transfert de l'énergie du circuit de découpage 10 à l'étage de sortie 30, l'enroulement 21 est parcouru par le courant $i_{21}$ composé du courant $i_{16}$ de forme triangulaire et du courant de l'enroulement 22 induit en forme de dent de scie, superposés et la tension $v_{21}$ qui apparaît à ses bornes, illustrée sur les diagrammes (C) des figures 2 et 3, est sensiblement analogue à celle $V_{220}$ aux bornes de l'interrupteur de balayage 35, 36 mais avec une valeur moyenne nulle.

L'énergie transmise par le transformateur 20 sera donc approximativement égale au produit de la tension $v_{21}(t)$ et du courant $i_{21}(t)$ multiplié par le cosinus de l'angle de phase $\varphi$, si l'on considère les ondes fondamentales à la fréquence de ligne (15.625 Hz). Ceci est d'ailleurs vrai aussi pour chacun des harmoniques des ondes de courant $i_{21}(t)$ et de tension $v_{21}(t)$, si l'on les développe en séries de Fourier.

L'energie cédée pendant chaque période de ligne $T_H$ par le circuit de découpage 10 à l'étage de sortie 30 par l'intermédiaire du transformateur 20 peut donc s'écrier:

$$E_H = \int_o^{T_H} v_{21}(t).i_{21}(t).dt.$$

Dans l'inductance 16, en première approximation, le courant $i_{21}(t)$ est la somme d'une composante alternative $i_A(t)$ et d'une composante continue $I_C$ et en considérant que les pertes propres du circuit de découpage 10 sont négligeables, que la valeur moyenne de la tension $v_{21}$ est nulle, et que la composante continue $I_C$ du courant $i_{21}$ n'intervient pas dans le transfert d'énergie, on peut écrire que l'énergie fournie par la source continue pendant cette période $E_s = V_A.I_C.T_H$ et l'énergie alternative fournie par le circuit de découpage

$$10 \quad E_H = \int_o^{T_H} v_{21}(t).i_A(t).dt$$

sont sensiblement égales, c'est-à-dire

$$V_A.I_C.T_H = \int_o^{T_H} v_{21}(t).i_A(t).dt,$$

d'où il ressort qu'il y a un courant continu moyen

$$I_C = \frac{1}{V_A.T_H} \int_o^{T_H} v_{21}(t).i_A(t).dt$$

fourni par la source 5 qui est une conséquence de l'échange d'énergie entre l'enroulement 21 et notamment l'enroulement 22. L'énergie alternative cédée $E_H$ et, par conséquent, le courant continu $I_C$ de la source 5 varie en fonction du cosinus de l'angle de phase $\varphi$ entre chacune des harmoniques respectives du courant $i_{21}(t)$ et de la tension $v_{21}(t)$. On peut donc obtenir la regulation en faisant varier la phase de l'onde du courant $i_{21}(t)$ dans l'enroulement d'alimentation 21 par rapport à celle de la tension $v_{21}(t)$ aux bornes de celui-ci, pour stabiliser le balayage (l'amplitude crête-à-crête du courant $i_{31}$) et/ou la T.H.T., en agissant sur la charge fournie au condensateur 33 durant chaque cycle.

Ceci est illustré respectivement sur les diagrammes (F) des figures 2 et 3 montrant la puissance instantanée $E_i = v_{21}(t).i_{21}(t)$ correspondant à deux angles de phase différents entre les ondes $v_{21}$ et $i_{21}$, indiquant respectivement des transferts d'énergie miminal (nul), lorsque les zéros du courant $i_{21}$ coïncident avec les maxima de la tension $v_{21}$ ou lorsque les maxima respectifs des tensions $v_{21}$ et $v_{19}$ sont déphasés d'une demi-période de ligne $T_H/2$ et maximal, lorsque les maxima de la tension $v_{21}$ et du courant $i_{21}$ coïncident, entre le circuit 10 et l'étage de sortie 30.

Sur le diagramme (F) de la figure 2, on peut voir que, lorsqu'il y a un décalage de phase entre les maxima correspondants (positifs) de $v_{21}(t)$ et de $i_{21}(t)$ d'un quart de période de ligne $(T_H/4)$ environ, le transfert d'énergie est nul, car il y a égalité entre les surfaces délimitées par la courbe et l'abscisse, respectivement situées au-dessus et au-dessous de celle-ci (symétrie), donnant une valeur moyenne nulle en ce qui concerne l'énergie fournie.

Par contre sur le diagramme (F) de la figure 3, où le produit $v_{21}(t).i_{21}(t)$ correspond à une coïncidence de phase entre les maxima respectifs de la tension $v_{21}$ et du courant $i_{21}$, on peut constater que lorsque l'on soustrait des surfaces au-dessus de l'abscisse, les surfaces correspondant aux triangles hâchurés au dessous de celle-ci, il subsiste du côté positif trois zones dont les surfaces correspondent à l'énergie effectivement transféré, dont la valeur moyenne E

$$E_H = \frac{1}{T_H} \int_o^{T_H} v_{21}(t).i_{21}.dt$$

est positive et démontre une fourniture d'énergie effective à l'étage de sortie 30, qui se traduit par une tension continue $V_{33}$ aux bornes du condensateur 33 qui constitue pendant l'aller du balayage (fermeture de l'interrupteur 35, 36) l'unique charge de l'enroulement 22 (la borne 220 étant réunie à la masse 39).

On a donc démontré ci-dessus qu'en faisant varier le déphasage entre les maxima correspondants des ondes $v_{21}(t)$ et $i_{21}(t)$ entre O et $T_H/4$ on peut faire varier l'énergie transmise et, par conséquent, la tension $V_{221}$ aux bornes du condensateur 33 qui alimente l'étage de sortie 30.

Lorsque le déphasage relatif entre $v_{21}(t)$ et $i_{21}(t)$ dépasse le quart de la période de ligne, comme par exemple lorsque l'amplitude crête négative de $v_{21}(t)$ coïncide avec l'amplitude crête négative de $i_{21}(t)$, c'est-à-dire un déphasage égal à une demi-période de ligne $(T_H/2)$, le terme de l'énergie $E_H$ devient négatif ce qui indique que c'est l'étage de sortie 30 qui alimente le circuit de découpage 10, plus précisément la source de tension 5 (condensateur 4). Ceci n'est durablement possible que si c'est l'étage de sortie 30 et donc le condensateur 33 qui est alimenté par un montage redresseur, démontrant ainsi la reversibilité du dispositif d'alimentation conforme à l'invention contrairement aux alimentations à découpage classiques.

La régulation est donc effectuée en faisant varier la phase de l'ouverture de l'interrupteur 15 du circuit de découpage 10 par le blocage du transistor 11, par rapport à celle de l'ouverture de l'interrupteur de balayage 36, 35 commandée par l'oscillateur de ligne (non représenté) qui est géneralement asservi en fréquence et en phase aux impulsions de synchronisation-ligne du signal vidéo-complexe.

Un tel retard de phase variable est obtenu ici partir des impulsions de retour-ligne prélevées sur l'un des enroulements du transformateur 20, tels que l'enroulement 21 lui-même ou bien, comme illustré sur la figure 1, l'enroulement auxiliaire 25. Ces impulsions peuvent déclencher un basculeur monostable de durée variable en fonction de la tension d'erreur fournie par un comparateur en forme d'amplificateur différentiel, dont l'une des entrées reçoit une tension correspondant soit à l'amplitude positive de $v_{21}(t)$ proportionnelle à la tension $V_{33}(V_{221})$ aux bornes du condensateur d'alimentation 33 de l'étage de sortie 30, soit à l'amplitude crête-à-crête de l'impulsion de retour-ligne, qui est proportionnelle à la T.H.T., soit à une combinaison de ces deux critères. L'autre entrée de l'amplificateur différentiel reçoit une tension continue de référence éventuellement ajustable pour permettre de réglage de la T.H.T. et/ou de l'amplitude du courant de balayage horizontal.

Il est à noter ici que l'enroulement d'alimentation 21 peut être connecté entre la borne 6 du condensateur 4 et la self de choc 14 dans deux sens opposés, de sorte que les impulsions de retour-ligne peuvent apparaître sur sa jonction avec la self 14 avec des polarités opposées dont il résulte deux possibilités de phase relative de la tension $v_{21}(t)$ par rapport au courant $i_{21}(t)$ de cet enroulement 21.

Sur la figure 4, on a représenté un bloc-diagramme partiel (sans dispositif de démarrage) d'un mode de réalisation simple du circuit de régulation 40 qui commande le blocage du transistor 11 du circuit de découpage 10 avec un retard variable par rapport à l'impulsion de retour-ligne, en fonction de l'amplitude crête négative du signal $v_{25}(t)$ fourni par l'enroulement auxiliaire 25 du transformateur 20.

Le circuit de régulation 40 de la figure 4, est alimenté sur sa première entrée 401 par le signal $v_{25}(t)$ fourni par l'une des bornes 250 de l'enroulement auxiliaire 25 et qui est sensiblement l'inverse du signal $v_{21}(t)$ illustré par les diagrammes (C) respectifs des figures 2 et 3, où l'on distingue, au cours de chaque période de ligne, une impulsion de retour-ligne de polarité positive et un plateau négatif dont l'amplitude est proportionnelle à la tension continue $V_{33}$ aux bornes du condensateur 30. Cette première entrée 401 alimente, à travers une première diode 410, l'entrée de déclenchement 411 d'un premier basculeur monostable 41, à durée variable produisant sur sa sortie 413, en réponse au front de montée de l'impulsion de retour, un signal rectangulaire dont la durée varie en fonction d'une tension continue appliquée sur son entrée de commande de durée 412.

Des basculeurs monostables à durée d'impulsion variable en fonction d'une tension continue sont connus et un exemple de réalisation en est décrit, par exemple, dans la publication FR—A—2.288.338.

Cette tension continue de commande de la durée l'impulsion est obtenue à l'aide d'un montage redresseur 42 alimenté également par cette première entrée 401 et comportant une seconde diode 420 connectée de façon à conduire uniquement pendant que le signal $v_{25}(t)$ est négatif, un condensateur 421 en série avec la diode 420 emmagasinant les valeurs de crête négatives de $v_{25}(t)$, un montage diviseur potentiométrique résistif 422, 423 monté en parallèle avec le condensateur 421 et un inverseur de polarité 424 alimenté par le point milieu du diviseur 422, 423 et fournissant une tension positive de même niveau en réponse à une tension négative d'entrée, les bornes respectives du condensateur 421 et du diviseur 422, 423, non reliées à la diode 420, étant réunies ensemble à la masse primaire 8.

La tension positive proportionnelle à $V_{33}$ fournie par l'inverseur 424 alimente une première entrée 431 d'un comparateur de tension analogique 43 dont la seconde entrée 432 reçoit une tension de référence stabilisée, par exemple, à l'aide d'un montage 44 alimenté par la tension du réseau redressée et filtrée $V_6$ à travers une seconde entrée 402 du circuit 40. Ce montage 44 comprend une résistance 440 et une diode Zener 441 connectées en série entre l'entrée 402 et la masse primaire 8 et il fournit, à l'aide d'un montage diviseur résistif 442, éventuellement ajustable, connecté en parallèle avec la diode Zener 441, la tension de référence à l'entrée 432 du comparateur 43. La sortie 433 du comparateur 43, reliée à l'entrée de commande 412 du premier basculeur monostable 41, lui fournit une tension proportionnelle à la différence entre les tensions respectivement appliquées sur ses entrées 431 et 432, de manière à faire varier le retard du blocage du transistor de découpage 11 par rapport à celui du transistor de balayage 36 (figure 1) afin de stabiliser la tension continue d'alimentation $V_{33}$ de l'étage de sortie 30.

Les fronts de montée des impulsions fournies par la sortie 413 du basculeur 41 coïncidant sensiblement avec ceux des impulsions de retour-ligne, leurs fronts de descente ou de chute qui se produisent avec des retards variables par rapport aux premiers sont utilisés pour déclencher, éventuellement à travers un étage inverseur 450, un second basculeur monostable 45 dont la sortie alimente la base du transistor hâcheur 11 pour le bloquer. Ce second basculeur monostable 45 fournit à cette base des signaux rectangulaires négatives à la fréquence de ligne, de durée constante, supérieure à la demi-période d'oscillation du circuit résonnant 13, 16 et donc à la demi-période de ligne ($>T_H/2$) et inférieure à trois quarts de cette même période ($<3T_H/4$) de façon à permettre au transistor 11 de reprendre le courant $i_{16}(t)$ parcourant l'inductance 16, lorsque le courant dans la diode 12 s'annule.

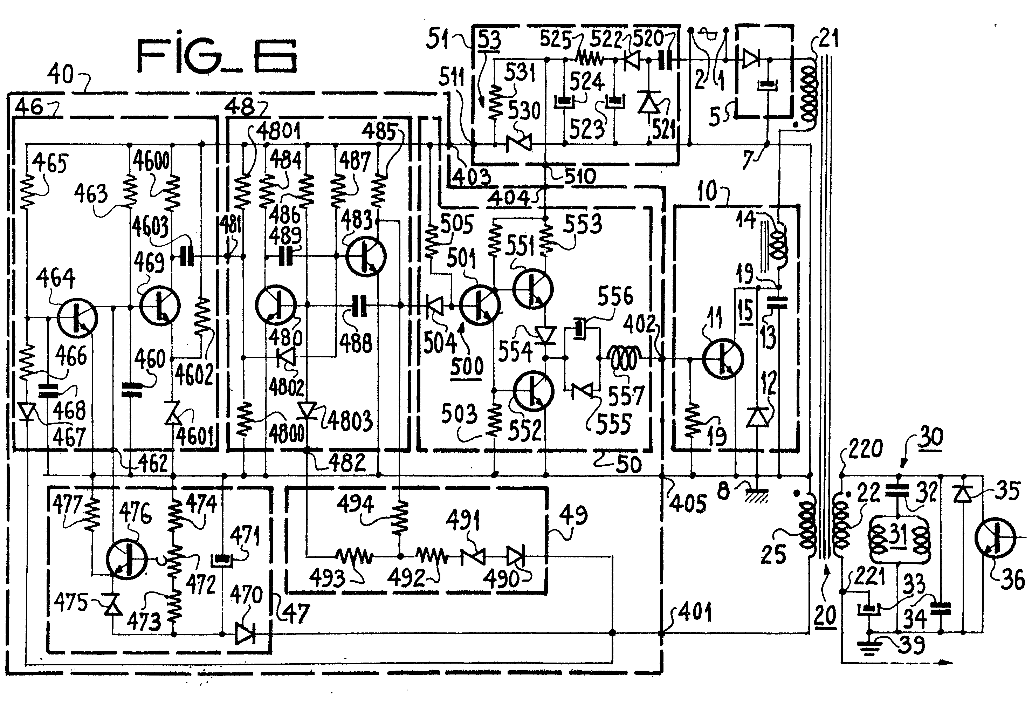

La figure 5 est un bloc-diagramme du mode de réalisation préféré d'un circuit de régulation 40 (de la figure 1) commandant le transistor 11 du circuit de découpage 10, suivant l'invention.

Sur la figure 5, le circuit de régulation 40 comporte une entrée 401 reliée à l'une des bornes de l'enroulement auxiliaire 25 du transformateur de ligne 20 qui alimente en parallèle une première entrée de commande 461 d'un étage déphaseur 46, l'entrée d'un étage régulateur 47 et, éventuellement, l'entrée d'un circuit de synchronisation 49. La sortie de l'étage régulateur 47 alimente une seconde entrée de régulation 462 de l'étage déphaseur 46, ces deux étages 46, 47 formant ensemble un générateur de retard variable. La sortie de l'étage déphaseur 46 alimente une première entrée de déclenchement 481 d'un multivibrateur astable 49 dont la seconde entrée de synchronisation 482 est alimentée par la sortie du circuit de synchronisation 49. Ce circuit de synchronisation 49, dont le fonctionnement sera décrit plus loin, n'est nécessaire que si la fréquence d'oscillation autonome du multivibrateur 48 est supérieure à la fréquence de ligne. Dans le cas contraire, le multivibrateur 48 est synchronisé de manière classique, par les impulsions de déclenchement appliquées à son entrée 481. La sortie du multivibrateur astable 48 alimente l'entrée d'un étage d'attaque ou de commande 50 constitué par un amplificateur. La sortie de l'étage de commande 50 (appelé "driver" dans la littérature anglo-américaine), reliée à la sortie 402 du circuit de régulation 40, alimente la base du transistor de commutation 11 du circuit de découpage 10.

L'enroulement auxiliaire 25 fournit à l'entrée 401 du circuit de régulation une forme d'onde de tension comprenant les impulsions de retour-ligne avec une polarité négative, par exemple, semblable à celle représentée sur les diagrammes (C) des figures 2 et 3. Ces impulsions de retour-ligne appliquées à l'entrée 461 de l'étage déphaseur 46 ou générateur de retard, commandent le déclenchement d'un générateur de signal fournissant une tension en forme de dent-de-scie positive qui est appliqué à l'une des entrées d'un étage comparateur de tension dont l'autre entrée est alimentée par une tension de reference fixe et qui bascule de son état "haut" à son état "bas" lorsque l'amplitude de la tension en dent de scie dépasse la valeur de la tension de référence. L'étage de régulation 47 reçoit également les impulsions de retour-ligne, les redresse et transmet à l'entrée de régulation 462 de l'étage déphaseur 46 un signal en forme de courant permettant de modifier la pente de la dent de scie en fonction de l'amplitude de l'impulsion de retour-ligne qui est fonction de la tension continue aux bornes du condensateur d'alimentation 33 (figure 1) de l'étage de sortie 30. Pour obtenir une régulation de la tension $V_{33}$, le déphasage doit croître avec la valeur de celle-ci en réduisant le transfert d'énergie entre les circuits 10 et 30. Par conséquent, la pente de la dent de scie doit décroître avec l'augmentation de l'amplitude de l'impulsion de retour. L'étage comparateur du déphaseur 46 alimente l'entrée de déclenchement 481 du multivibrateur astable 48 pour le déchlencher avec le déphasage variable par rapport au front de montée de l'impulsion de retour, qui correspond au transfert d'énergie désiré. Le multivibrateur astable 48 est, de préférence, synchronisé en fréquence avec l'étage de sortie du balayage-ligne 30 d'une manière qui sera expliquée plus loin, à l'aide du circuit de synchronisation 49 qui alimente son entrée de synchronisation 482. La sortie du multivibrateur 48 alimente l'entrée de l'étage d'attaque 50 du transistor de découpage 11.

Pour permettre le démarrage du circuit de découpage 10 avant la mise en route du circuit de balayage-ligne et, notamment de son étage de sortie 30, le multivibrateur astable 48 doit osciller de façon autonome, et l'étage 50 doit amplifier le signal sensiblement carré qu'il fournit. A cette fin, une source de tension d'alimentation continue autonome 51 est reliée aux bornes 1, 2 d'alimenation du réseau alternatif et les tensions qu'elle fournit alimentent les bornes d'alimentation 403, 404 et 405 du circuit de régulation 40. Lorsque le circuit de découpage 10 démarre en fonctionnement autonome pendant que le circuit de balayage-ligne, comprenant en cascade un oscillateur de ligne, un étage d'attaque et l'étage de sortie 30, n'est pas encore alimenté, le courant de découpage $i_{16}(t)$ parcourant l'enroulement d'alimenation 21 est induit dans l'enroulement 22 et il est redressé par la seconde diode 35 en chargeant positivement le condensateur d'alimentation 33 qui ensuite alimente étages du circuit de balayage par une tension continue, de façon à les faire démarrer. Ce démarrage et la régulation consécutive seront expliqués plus en détail dans ce qui suit.

La figure 6 est un schéma de principe du mode de réalisation préféré du circuit de régulation 40 dont le schéma synoptique a été illustré sur la figure 5.

Sur la figure 6, la source de tension d'alimentation 51 du circuit de régulation 40 comporte un montage redresseur 52 du type doubleur de tension à une alternance comprenant deux diodes 521, 522 en série. La première diode 521 est reliée par son anode à la seconde borne 2 d'alimenation par le réseau, qui est reliée à la mass primaire 8, et par sa cathode à l'anode de la seconde diode 522 dont la cathode est reliée à l'armature positive d'un premier condensateur de filtrage électrochimique 523. L'armature négative du premier condensateur de filtrage 523 est reliée à l'anode de la première diode 521, donc également à la masse primaire 8. La jonction de la cathode de la première diode 521 et de l'anode de la seconde 522 est couplée à la première borne d'alimentation 1 par le réseau, par l'intermédiaire d'un condensateur de couplage 520 qui transmet au montage redresseur 52 la tension du réseau et dont la capacité est choisie en fonction de la tension continue désirée (la chute de tension aux bornes de cette capacité 520 de l'ordre de quelques microfarads permet d'obtenir une tension redressée et filtrée de 15 volts environ). La jonction de l'armature positive du premier condensateur de filtrage 523 est réunie à l'armature positive d'un second condensateur de filtrage 524 à travers une résistance 525, l'armature négative de ce second condensateur 524 étant reliée à la masse primaire 8. La borne positive de ce second condensateur 524 fournit une première tension redressée et filtrée $V_F$, d'une part, à travers la première borne de sortie 510 de la source 51 à la première borne d'alimentation positive 404 du circuit de régulation 40 et, d'autre part, à un montage de stabilisation 53 comprenant en série une résistance 531 et une diode Zener 530 dont l'anode est reliée à la masse primaire 8. La jonction de la résistance 531 avec la cathode de la diode Zener 530 est reliée à la seconde sortie 511 de la source 51, qui fournit une seconde tension régulée $V_R$ alimentant la seconde entrée d'alimentation 403 du circuit de régulation 40.

La première entrée d'alimentation 404 fournis-sant une première tension $V_F$(15 V) plus élevée que la seconde tension régulée ($V_R$(5 V), alimente uniquement l'étage de commande 50 du transistor de découpage 11. L'étage de commande 50 comporte en cascade un étage déphaseur 500 (appelé "phase splitter" dans la littérature anglo-américaine) et un étage de sortie 550 du type "push-pull série", souvent utilisés dans les circuits logiques intégrés du type TTL. L'étage déphaseur 500 comporte un premier transistor NPN 501 dont le collecteur est réuni à travers une résistance collecteur 502 à la première entrée d'alimentation 404 et dont l'émetteur est réuni à travers une résistance émetteur 503 à la masse primaire 8 par l'intermédiaire de la troisième borne d'alimentation 405 du circuit 40. La base du transistor 501 est reliée à la sortie du multivibrateur astable 48 par l'intermédiaire d'une diode 504 et à la seconde entrée d'alimentation 403, par l'intermédiaire d'une résistance de polarisation 505. L'étage de sortie 550 comporte un second et un troisième transistors NPN 551 et 552. Le collecteur du second transistor 551 est relié à travers une résistance 553 à la première entrée d'alimentation 404, sa base étant reliée au collecteur du premier transistor 501. L'émetteur du second transistor 551 est relié à l'anode d'une diode 554 dont la cathode est reliée au collecteur du troisième transistor 552. La base du troisième transistor 552 est reliée à l'emetteur du premier 501 et son émetteur, par la troisième borne d'alimentation 405, à la masse primaire 8. La jonction de la cathode de la diode 554 avec le collecteur du troisième transistor 552 est reliée à la cathode d'une diode Zener 555 et à l'armature positive d'un condensateur électrochimique 556, montés, en parallèle pour former une "pile" faci-litant le blocage du transistor de commutation 11. L'autre borne du montage parallèle 555, 556 est reliée, par l'intermédiaire d'un inducteur 557 (self de choc), à la sortie 402 du circuit de régulation 40, qui alimente la base du transistor de commutation 11.

L'étage de commande 50 est commandé par un multivibrateur astable du type symétrique 48 comportant deux transistors NPN 480, 483 montés en émetteur commun, c'est-à-dire avec leurs émetteurs reliés à travers la troisième borne d'alimentation 405, à la masse primaire 8. Les collecteurs des deux transistors 480, 483 sont respectivement réunis à la seconde entrée d'alimentation 403 recevant la tension stabilisée $V_R$, par l'intermédiaire de deux résistances-collecteur 484, 485. Les bases des deux transistors 480, 483 sont respectivement réunies au moyen de deux résistances de polarisation 486, 487 également à la seconde entrée d'alimentation 403. La base du premier transistor 480 est, par ailleurs, couplée au collecteur du second transistor 483 au moyen d'un premier condensateur 488 et la base du second transistor 483 est couplée au collecteur du premier 480 au moyen d'un second condensateur 489. Les valeurs respectives des résistances de polarisation 486, 487 et des condensateurs de couplage mutuel 488, 489 (en croix) des deux étages montés en émetteur commun déterminent, avec la valeur de la tension d'alimentation stabilisée $V_R$, les durées des demi-périodes de relaxation du multivibrateur 48 dont la somme (60 $\mu$s) est choisie, de préférence, inférieure à celle d'une période de ligne (64 $\mu$s).

En l'absence d'impulsions de retour-ligne provenant de l'étage de sortie du balayage-ligne 30 à travers l'enroulement auxiliaire 25, le multivibrateur 48 n'est alimenté ni sur son entrée de déclenchement 481, qui est reliée à la cathode d'une première diode 4802 dont l'anode est reliée à la base du second transistor 483, ni sur son entrée de synchronisation 482 qui est reliée à la cathode d'une seconde diode 4803 dont l'anode est reliée à la base du premier transistor 480. Il fonctionnera donc de manière autonome dès la mise sous tension des bornes d'alimentation secteur 1, 2 qui alimentent, d'une part, le montage redresseur 5 et, d'autre part, la source d'alimentation autonome 51. Celle-ci fournit alors au multivibrateur 48 une tension d'alimentation stabilisée $V_R$ et à l'étage d'attaque 50 une tension redressée et filtrée $V_F$. Lorsque le multivibrateur 48 se met à relaxer, il fournit sur sa sortie constituée par le collecteur de son second transistor 483, des signaux rectangulaires à deux niveaux ($V_R$ et $V_{CEsat}$) dont le plus bas provoque, à travers la diode 504 de couplage, le blocage du premier transistor 501 de l'étage de commande 50. Lorsque le premier transistor 501 est bloqué, la base du second transistor 551 de l'étage de sortie 50 est reliée, par l'intermédiaire de la résistance-collecteur 502, à la première entrée d'alimentation 404 du circuit 40 de façon à provoquer sa saturation. Le courant émetteur du second transistor 551 passe alors, à travers la diode 554, la diode Zener 555 et l'inducteur 557 (limitant le taux de montée du courant di/dt), dans la résistance 19 réunissant la base du transistor de découpage 11 à la masse primaire 8 et dans cette base, afin de permettre la saturation du transistor de découpage 11, le troisième transistor 552 étant alors bloqué par le blocage du premier 501. La chute de tension aux bornes de la diode Zener 555 permet de réduire la tension de polarisation positive de la base et de charger le condensateur 556 à la tension de Zener $V_z$ pendant ses périodes de conduction.

Lorsque le second transistor 483 du multivibrateur 48 a basculé de son état saturé dans son état bloqué, sa tension collecteur est égale à la tension stabilisée $V_R$ et la diode 504 se bloque. La base du premier transistor 501 de l'étage de commande 50 est alors reliée à la seconde entrée d'alimentation 403 ($+ V_R$) par la résistance 505, ce qui provoque sa saturation. Alors le courant émetteur de ce premier transistor 501 alimente la base du troisième transistor 552 qui devient également saturé, tandis que le second transistor 551, dont la base est à une tension ($V_{CEsat\ 501} + V_{BE\ 552}$) sensiblement égale à celle de son émetteur ($V_{F\ 554} + V_{BE\ 552}$), se bloque. La saturation du troisième transistor 552 amène d'abord la base du transistor de découpage 11 à une tension négative par rapport à son émetteur $V_{BE\ 11} = -V_z + V_{CEsat\ 552}$ de façon à le bloquer rapidement par une évacuation rapide des porteurs minoritaires de sa base, cette tension $V_{BE\ 11}$ tendant ensuite asymptotiquement vers zéro, du fait que le condensateur 556 se décharge à travers la résistance 19 et le troisième transistor 552 qui est saturé. Le transistor de découpage 11 restera bloqué pendant la demi-période entière d'oscill-ation du circuit résonnant $L_{16}$, $C_{13}$ et ne reprendra ensuite le courant de la diode 12 que s'il est déjà polarisé positivement sur sa base par le basculement du multivibrateur 48 dans l'état où son second transistor 483 redevient saturé de façon à rebloquer le premier transistor 501 et à resaturer le second transistor 551 du circuit de commande 50.

Le blocage et la conduction alternées de l'interrupteur bidirectionnel 15 provoquent l'apparition sur la borne 19 des demi-sinusoïdes de tension récurrentes, illustrées par les diagrammes (D) des figures 2 et 3, dont une fraction est également présente aux bornes de l'enroulement d'alimentation 21 du transformateur de ligne 20, d'où elles sont transmises avec une inversion de phase (polarité) et sans composante continue à l'enroulement 22 de l'étage de sortie du balayage-ligne 30. Les alternances négatives de ses formes d'ondes sur la borne 220 de l'enroulement sont alors redressées par la diode de récupération parallèle ("shunt") 35 dont le courant charge le condensateur d'alimentation 33 jusqu'à ce que la tension $V_{33}$ sur la borne 221, qui alimente l'ensemble du circuit de balayage-ligne, soit suffisante pour que l'oscillateur-ligne (non représenté) se mette à osciller de manière autonome, de façon à commander, à travers l'etage d'attaque ("driver", non représenté), le transistor de commutation 36 de l'étage de sortie 30. L'étage de sortie du balayage-ligne 30 commence alors à fournir, aux bornes de l'enroulement 22 du transformateur-ligne 20, des im-pulsions de retour-ligne $v_{220}(t)$, illustrées par les diagrammes (B) des figures 2 et 3. Ces impulsions sont transmises à l'enroulement auxiliaire 25 sans composante continue et avec une inversion de phase (négative), de façon à présenter une forme d'onde analogue à celui des diagrammes (C) des figures 2 et 3, permettant d'abord de synchroniser le multivibrateur 48 avec la fréquence de l'oscillateur-ligne par un asservissement original qui sera décrit plus loin, et ensuite de réguler la tension $V_{33}$ par la variation du retard entre les fronts de montée des impulsions de retour-ligne et l'instant de blocage du transistor de découpage 11 de l'interrupteur 15.

Lorsque le multivibrateur 48 et l'oscillateur de ligne fonctionnent de façon autonome et avec des fréquences différentes, ceci crée un

battement car il y a des variations aléatoires de la phase entre les impulsions de retour-ligne — $V_{220}(t)$ ou $v_{21}(t)$ — et la forme d'onde de la tension de découpage $v_{19}(t)$, de sorte que l'energie fournie (ou consommée) par le circuit de découpage 10 à (ou de) l'étage de sortie 30 varie d'un cycle à l'autre. Ceci a pour résultat observable, une fluctuation plus ou moins importante de l'amplitude des impulsions de retour-ligne $v_{220}(t)$, qui semblent être modulées en amplitude par un signal sinusoïdal dont la fréquence est égale à la différence entre celle du multivibrateur 48 et celle de l'oscillateur-ligne.

Si l'on choisit de synchroniser le multivibrateur astable 48 de façon classique uniquement au moyen d'impulsions de commande périodiques dérivées des impulsions de retour-ligne à travers un circuit de retard variable permettant la régulation, il suffit que sa fréquence d'oscillation autonome soit inférieure à celle de l'oscillateur-ligne. On obtient alors au démarrage des tensions crête $V_{19}$ plus élevées (surtensions) sur le collecteur du transistor 11 pendant son blocage, du fait que, dans la formule $V_{19\,max} \cdot t_B = V_{A\,max} \cdot T_{48\,A}$, où $V_{19\,max}$ est l'amplitude crête de la tension collecteur (à la borne 19), $t_B$ le temps de blocage de l'interrupteur 15, $V_{A\,max}$ la tension maximale d'alimentation fournie par le redresseur 5 et $T_{48\,A}$ la période autonome du multivibrateur 48, $T_{48\,A}$ est supérieure à $T_H$. Si l'on accepte cette surtension $v_{19\,max}$ en la limitant par un choix du temps de saturation $t_s$ peu supérieur au temps de blocage $t_B$ qui est toujours égal et déterminé par le demi-période d'oscillation de $L_{16}$ et $C_{13}$, il ne sera pas nécessaire d'asservir le multivibrateur 48 préalablement à la régulation et le circuit de synchronisation 49 peut être omis.

Si, par contre, on désire éviter les dépassements de la tension collecteur crête $V_{19\,max}$ au démarrage, on choisit une période autonome $T_{48\,A}$ du multivibrateur 48 inférieure à la période de ligne $T_H (64\,\mu s)$ et on le synchronise en agissant uniquement sur la durée de l'état bloqué du premier transistor 480 du multivibrateur 48, en la prolongeant. Pendant ce même intervalle de temps, le second transistor 483 du multivibrateur 48 et le second transistor 551 de l'étage d'attaque 50 sont saturés, et les premier 501 et troisième 552 transistors de cet étage 50 sont bloqués de sorte que la base du transistor de découpage 11 est polarisée pour conduire.

Cette prolongation est effectuée à l'aide d'un réseau 49 comportant une diode 490 dont la cathode est reliée à l'entrée 401 du circuit de régulation 40 recevant les impulsions de retour-ligne de l'enroulement 25 avec une polarité négative et sans composante continue. L'anode de cette diode 490 est reliée à celle d'une diode Zener 491 dont la cathode est reliée à l'une des bornes d'une première résistance 492. L'autre borne de cette première résistance 492 est reliée, d'une part par l'intermédiaire d'une seconde résistance 493, à l'entrée de synchronisation 482 du multivibrateur astable 48 et, d'autre part par l'intermédiaire d'une troisième résistance 494, au collecteur du second transistor 483 du multivibrateur, afin que l'impulsion de retour-ligne négative et ébasée par la diode Zener 491, ne puisse pas agir sur la base du premier transistor 480 pendant ses intervalles de saturation de façon à le bloquer imtempestivement.

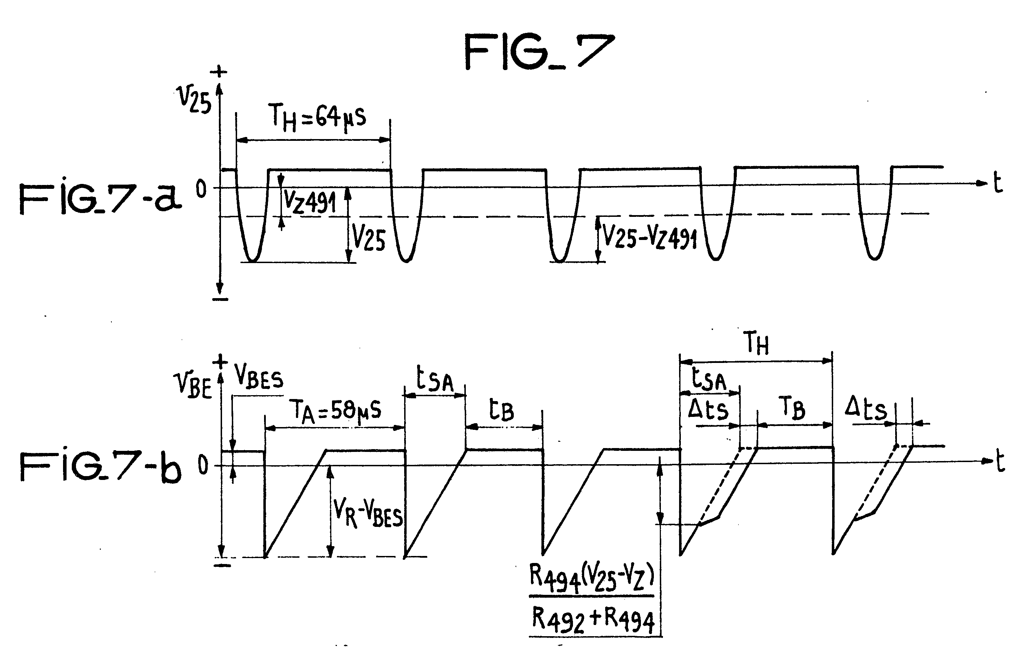

Le processus de l'asservissement de la fréquence du multivibrateur 48 au moyens des impulsions de retour-ligne est illustrée par des diagrammes de formes d'onde de la figure 7.

Sur la figure 7, le diagramme A représente la forme d'onde aux bornes de l'enroulement auxiliaire 25 du transformateur de ligne 20 où des impulsions de retour-ligne apparaissent sous la forme de demisinusoïdes négatives d'amplitude $V_{25}$ à la fréquence de ligne (15.625 Hz). Le diagramme B représente la forme d'onde de la tension $v_{BE\,480}$ sur la base du premier transistor 480. Celle-ci comporte un premier intervalle de temps $t_{SA}$ pendant lequel l'interrupteur de découpage 15 est conducteur et le transistor 480 bloqué, qui dépend uniquement de la valeur des composants reliés à cette base, nommément la résistance 486 et le condensateur 488 et de la tension d'alimentation $V_R$ de cette résistance 484, et un second intervalle de temps $t_B$ de durée fixe, pendant lequel l'interrupteur de découpage 15 est bloqué et le transistor 480 saturé. La somme des intervalles $t_{SA}$ et $t_B$ représente la période de fonctionnement autonome $T_A$ du multivibrateur 48 (de l'ordre de 58 $\mu s$, par exemple).

Sur la figure 7, les trois premières périodes de fonctionnement autonome du multivibrateur 48 ne sont pas modifiées, car soit l'impulsion de retour-ligne se produit en dehors de l'intervalle de blocage $t_{SA}$ du transistor 480, soit son amplitude ébasée par la diode Zener 491 et réduite par la diviseur de tension résistif 492, 494, c'est-à-dire $(V_{25} - V_{Z\,491}) \cdot R_{494}/(R_{492} + R_{494})$, est inférieure en valeur absolue à la tension base-émetteur instantanée $v_{BE\,480}(t)$. Dès l'instant où la cathode de la diode séparatrice 4803 devient plus négative que son anode reliée à la base du transistor 480, elle commence à conduire un courant $I_{493}$ qui décharge le condensateur 488 à travers la résistance 493 en série avec les résistances 492 et 494 en parallèle. Le courant $I_{493}$ doit être souistrait du courant $I_{486}$ chargeant le condensateur pendant tout le temps où l'amplitude de l'impulsion de retour-ligne dépasse la tension $v_{BE}$. Ceci a pour effet de décaler dans le temps une partie de la forme d'onde de charge du condensateur 496 et d'allonger ainsi le temps de blocage $t_{SA}$ du transistor 480 d'un temps $\Delta t_s$ qui croîtra jusqu'à ce que la période allongée du multivibrateur 48 soit égale à la période de ligne $T_H$. Du fait que le temps de conduction de l'interrupteur 15 est prolongé, l'énergie emmagasinée dans l'inducteur 16 augmente. Ceci augmente la tension $V_{33}$ et l'amplitude de l'impulsion de retour-ligne.

Le processus d'asservissement du multivibrateur 48 en fréquence doit nécessairement mener à l'égalité de ces périodes, car une inégalité donne lieu à une fluctuation de l'amplitude crête de l'impulsion de retour-ligne dans un sens qui affecte la durée du temps de blocage $t_{SA} + \Delta t_S$ du transistor 480 en sens inverse.

Après l'asservissement de la fréquence du multivibrateur astable 48, on peut procéder à la régulation par la variation du déphasage entre les instants de blocage respectifs du transistor de balayage 36 et du transistor de découpage 11, au moyen des étages déphaseur 46 et régulateur 47 du circuit de régulation 40, qui forment ensemble le générateur de retard variable.

L'étage déphaseur 46 comporte un générateur de dents de scie comprenant un premier condensateur 460 dont l'une des bornes est reliée à la masse primaire 8 et dont l'autre borne est reliée à l'une des bornes d'une première résistance 463 dont l'autre borne est reliée à la seconde entrée d'alimentation 403 recevant la tension stabilisée $+ V_R$, et un interrupteur destiné à périodiquement court-circuiter le premier condensateur 460. Cet interrupteur comprend un premier transistor de commutation NPN 464 dont le collecteur est relié à la jonction du premier condensateur 460 et de la première résistance 463, dont l'émetteur est relié à la masse primaire 8 et dont la base est réunie, par l'intermédiaire d'une seconde résistance 465, à la seconde entrée d'alimentation 403 et, par l'intermédiaire d'une troisième résistance 466, à l'anode d'une diode 467 dont la cathode est reliée à l'entrée de commande 461 de l'étage déphaseur 46, qui reçoit des impulsions de retour-ligne négatives de l'entrée 401 du circuit 40. La base du premier transistor 464 est par ailleurs couplée à la masse primaire 8 par l'intermédiaire d'un second condensateur 468.

Lorsque l'entrée 401 du circuit 40 reçoit une impulsion de retour-ligne négative, la diode 467 se met à conduire et son courant provoque des chutes de tension aux bornes des résistances 465, 466 en série qui amènent le transistor 464 au blocage en le polarisant négativement. Le second condensateur 468 se change alors à une tension négative qui prolongera la durée du blocage du transistor 464 au-delà de la disparition de l'impulsion de retour-ligne, sur une partie de la période d'aller du balayage, afin de disposer d'une plage de régulation suffisante.

Dès la cessation de l'impulsion de retour négative, la diode 467 se bloque et le second condensateur 468 est chargé graduellement à travers la résistance 465 jusqu'à une tension $V_{BE}$ positive de 0,7 volts environ, où le transistor 464 devient saturé et décharge le premier condensateur 460.

Pendant la durée du blocage du premier transistor 464, le premier condensateur 460 est chargé quasi-linéairement à travers la résistance 463 en fournissant une tension en forme de dent de scie positive à la base d'un second transistor NPN 469, dont le collecteur est réuni, par l'intermédiaire d'une quatrième résistance 4600, à la seconde borne d'alimentation 403 ($V_R = + 5$ V). L'émetteur du second transistor 469 est réuni, d'une part, à la cathode d'une diode de Zener 4601 dont l'anode est reliée à la masse primaire 8 et, d'autre part, à la seconde borne d'alimentation 403 à travers une cinquième résistance 4602 qui permet de polariser l'émetteur du second transistor 469 à une tension $V_Z$ fixe (comprise entre 2 et 3 volts environ).

Le second transistor 469 forme, avec les résistances 4600, 4602 et la diode Zener 4601, un étage comparateur de tension analogique qui est bloqué jusqu'à ce que la tension appliquée à sa base dépasse une tension de seuil résultant de l'addition de la tension Zener $V_Z$ de la diode 4601 à la tension $V_{BES}$ de 0,7 volts environ, pour laquelle le second transistor 469 est saturé.

Lorsque le second transistor 469 passe de son état bloqué à son état saturé, sa tension collecteur $v_{C\,469}$ passe de $V_R$ à $V_Z + V_{CEsat}$. Cette transition négative est transmise à travers un condensateur de couplage 4603 à l'entrée de déclenchement 481 du multivibrateur astable 48, qui est reliée, d'une part, à la cathode de la première diode 4802 dont l'anode est reliée à la base du second transistor 483 et, d'autre part, aux premières bornes de deux résistances 4800 et 4801 formant un diviseur de tension résistif et dont les secondes bornes sont respectivement reliées à la masse primaire 8 et à la seconde borne d'alimentation 403 du circuit 40. Cette transition négative transmise à la base du second transistor 483 du multivibrateur 48 provoque son blocage et, de la manière décrite précédemment, également le blocage du transistor de découpage 11.

La régulation de la puissance transmise par le circuit de découpage 10 à l'étage de sortie du balayage-ligne 30 est effectuée par la variation du retard de phase entre les instants de blocage respectifs des transistors de balayage 36 et de découpage 11, à l'aide de l'étage régulateur 47 qui fait varier la pente de la tension de charge du condensateur 460 en fonction de l'un des paramètres contenus dans l'impulsion de retour-ligne.

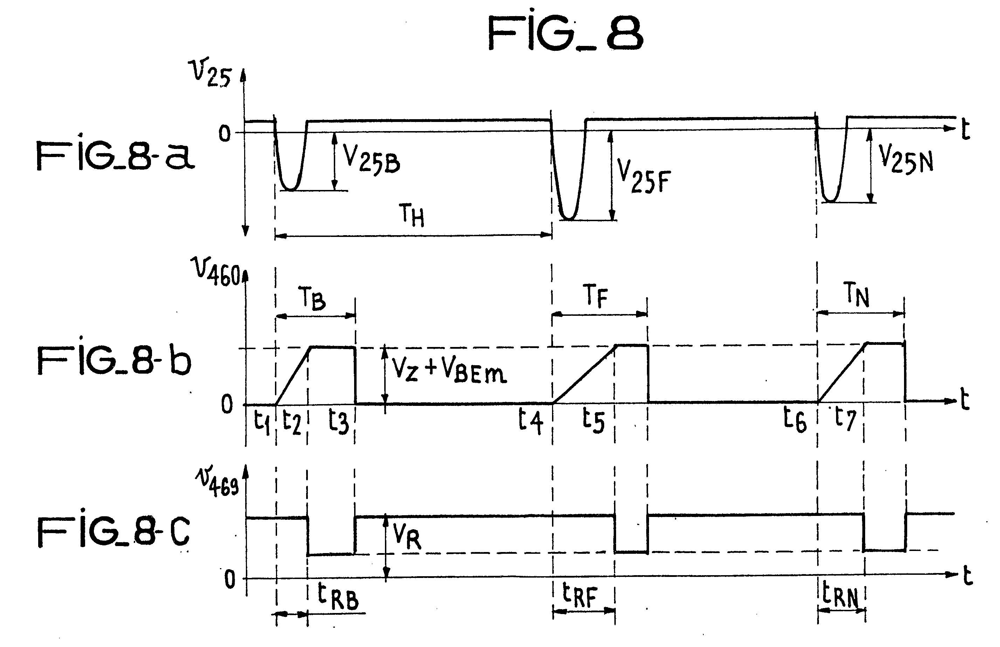

Le fonctionnement conjugué des étages déphaseur 46 et régulateur 47 sera expliqué à l'aide de la figure 8, illustrant des formes d'onde de tension à trois points de ces circuits 46, 47.

L'étage régulateur 47 comporte une diode 470 dont la cathode est reliée à l'entrée 401 du circuit 40 recevant les impulsions de retour-ligne de polarité négative et dont l'anode est reliée à l'armature négative d'un condensateur de filtrage 471, à l'une des bornes d'un montage diviseur de tension résistif comprenant un potentiomètre 472 entre deux resistances 473, 474 en série et l'anode d'une diode Zener 475. La cathode de la diode Zener 475 est reliée, d'une part, à l'une des bornes d'une troisième résistance 477 dont l'autre borne est reliée à la masse primaire 8 et, d'autre part, à l'émetteur d'un transistor NPN 476 dont la base est reliée au curseur du potentiomètre 472 et dont le collecteur est relié à l'entrée de régulation 462 de l'étage déphaseur 46, qui est reliée à la jonction de son premier condensateur 460 avec sa première résistance 463 et avec le collecteur de son premier transistor 464.

La diode 470 forme avec le condensateur 471 un redresseur des crêtes négatives des impulsions de retour-ligne, le condensateur 471 fournissant à ses bornes une tension qui est fonction de l'amplitude crête négative de celle-ci.

Cette tension crête redressée est appliquée, d'une part, au montage diviseur résistif 472—474 de sorte que le curseur du potentiomètre 472 fournit une tension qui est une fraction predéterminée et réglable de celle-là et, d'autre part, au montage série de la diode Zener 475 et de la résistance 477 polarisant cette diode 475. Dès que l'amplitude des impulsions de retour-ligne dépasse la tension de Zener $V_z$ de la diode 475, celle-ci est débloquée de façon à fournir sur sa cathode une tension égale à la différence entre la tension crête redressée et la tension de Zener $V_z$. La tension de cathode de la diode Zener 475 polarise l'émetteur du transistor 476 dont la base est polarisée par le montage diviseur 472—474 et qui commence à conduire dès que la fraction de la tension redressée fournie par le curseur du potentiomètre est supérieure à la tension de Zener $V_z$ en valeurs absolues. Le transistor 476 constitue alors une source de courant constant, proportionnel à sa tension base-émetteur $V_{BE}$, c'est-à-dire à $V_B$—$V_z$, lorsque celle-ci est positive. Le courant collecteur du transistor 476 est donc un courant qui décharge le condensateur 460 pendant les intervalles de blocage du transistor 464 de façon à réduire la pente de la dent de scie de tension aux bornes du condensateur 460. Plus la tension crête négative des impulsions de retour-ligne est importante, plus le courant collecteur du transistor 476 réduit la pente de façon à augmenter le temps de retard entre le front de montée de l'impulsion de retour-ligne et l'instant de transition du transistor comparateur 469 de son état bloqué à son état saturé.

Ceci est indiqué sur la figure 8, où le diagramme (A) montre la forme d'onde de tension $v_{25}(t)$ aux bornes de l'enroulement auxiliaire 25, dont les impulsions de retour-ligne présentent trois amplitudes différentes $V_{25\,B}$, $V_{25\,F}$ et $V_{25\,N}$, le diagramme (B) représente la forme d'onde de tension aux bornes du condensateur 460 correspondant à ces trois impulsions de retour-ligne, et le diagramme (C) représente la tension collecteur $v_{469}(t)$ du transistor comparateur 469.

Sur le diagramme (A) de la figure 8, la première impulsion de retour-ligne présente une amplitude $V_{25\,B}$ relativement faible qui n'entraîne pas la conduction du transistor de régulation 476. A cela correspondent sur le diagramme (B), la pente la plus forte de l'onde de tension $v_{469}(t)$ qui débute à l'instant $t_1$ du blocage du premier transistor 464 du déphaseur 46 et la durée la plus courte $T_B = t_3 - t_1$ de ce blocage du fait de la charge négative plus faible du condensateur 468. A l'instant $t_2$, lorsque la tension $v_{460}(t)$ devient égale à $V_z + V_{BEm}$, elle ne monte plus puisque la diode constituée par la jonction base-émetteur du second transistor 469 limite le niveau maximal de la tension et ce transistor 469 devient saturé. Ceci est illustré par le diagramme (C) de la figure 8, où l'on peut voir que la tension-collecteur $v_{C\,469}$ du second transistor 469 comporte un créneau négatif dont le niveau est égal à $V_z + V_{CEsat}$ et qui dure jusqu'à l'instant $t_3$ du déblocage du premier transistor 464 dechargeant le condensateur 460 et, par conséquent, bloquant le second transistor 469.

Du fait du faible retard de phase $t_{RB} = t_2 - t_1$ engendré par la montée rapide de la tension $v_{460}(t)$, le circuit de découpage 10 fournit une énergie maximale à l'étage de sortie 30 sous la forme d'une forte tension $V_{33}$ aux bornes du condensateur d'alimentation 33. Par conséquent, la prochaine impulsion de retour-ligne présentera une forte amplitude $V_{25\,F}$. Le transistor comparateur 476 se met à conduire dès que son $V_{BE}$ devient positif et le courant collecteur sera autant plus fort que l'est l'amplitude $V_{25\,F}$ à laquelle se charge le condensateur 471. Ce courant collecteur est à soustraire du courant de charge du condensateur 460 à travers la résistance 463; il entraîne donc une réduction sensible de la pente de la montée de la tension $v_{460}(t)$ qui se produit entre les instants $t_4$ et $t_5$. La durée de cette montée correspondant au retard de phase $t_{RF} = t_5 - t_4$, sera alors sensiblement plus longue que précédemment, ainsi que la durée de l'état bloqué $T_F$ du premier transistor 464. On voit donc sur les trois diagrammes que lorsque $V_{25\,F}$ est forte, le retard $t_{RF}$ est plus long et la durée de l'impulsion négative $T_F - t_{RF}$ est légèrement plus courte.

Ce retard plus long entraîne une réduction de la tension $V_{33}$ par rapport au cycle précédent où elle était trop forte, et l'impulsion de retour-ligne suivante (la troisième) présentera une amplitude $V_{25\,N}$ supérieure à $V_{25\,B}$ et inférieure à $V_{25\,F}$. Elle permettra d'obtenir au moyen du courant collecteur correspondant du transistor de régulation 476 une pente dont la montée d'une tension $V_{CE}$ sat proche de zéro jusqu'a une tension $V_z + V_{BEm}$, présente une durée égale à $t_{RN} = t_7 - t_6$. Si le curseur du potentiomètre 472 a été positionné de façon à ce que la tension d'alimentation $V_{33}$ permette d'obtenir une très-haute-tension du tube à rayons cathodique (non représenté) et/ou une amplutude de la dent de scie du courant de balayage horizontal correspondant à leurs valeurs nominales respectives, l'amplitude nominale $V_{25\,N}$ de l'impulsion de retour-ligne sera reproduite ensuite de façon récurrente.

Il est à remarquer ici que l'on peut également utiliser comme critère de régulation l'amplitude positive du signal $v_{25}(t)$, c'est-à-dire le plateau positif dont le niveau est proportionnel à la tension d'alimentation $V_{33}$, en utilisant un inverseur de phase analogique ou un autre enroulement du transformateur de ligne 20, par exemple.

On notera également ici que le principal avantage de la régulation par déphasage d'un circuit de découpage fonctionnant à rapport cyclique et à fréquence constants, par rapport à celle par la variation de l'une de ces derniers, est constituée par le fait que la tension crête appliquée au collecteur du transistor de découpage, lorsqu'il est bloqué, est fonction uniquement de la tension du réseau et dont la sécurité de fonctionnement est encore accrue grâce à la bobine de choc 14 qui fait que le couplage entre le circuit de découpage 10 et l'étage de sortie de balayage-ligne 30 est effectué par le courant en assurant une bonne protection au transistor de découpage haute-tension 11, relativement coûteux.

**Revendications**

1. Dispositif d'alimentation combiné avec un circuit de balayage-ligne d'un récepteur de télévision, dont l'étage de sortie (30) comporte un premier interrupteur électronique du type bidirectionnel (36, 35), commandé périodiquement pour être fermé pendant l'aller du balayage et ouvert pendant le retour de celui-ci, connecté en parallèle avec un premier montage série composé des bobines de déviation-ligne (31) et d'un premier condensateur (32), dit d'aller, alimentant ces bobines (31) pendant la fermeture du premier interrupteur (36, 35), avec un second condensateur (34), dit de retour, formant un circuit résonnant parallèle principalement avec l'inductance des bobines (31), pendant l'ouverture du premier interrupteur (36, 35), et avec un second montage série composé d'un premier enroulement (22) d'un transformateur (20), dit de ligne, et d'un troisième condensateur (33), dit d'alimentation, alimentant le premier enroulement (22) en tension continue pendant la fermeture du premier interrupteur (36, 35), le dispositif d'alimentation comprenant un circuit de découpage (10) qui comporte, connectés en série entre les bornes (6, 7) d'une source de tension d'alimentation continue (5), une inductance, dite de découpage (16) et un second interrupteur électronique bidirectionnel (15) commandé, cette inductance de découpage (16) comprenant un second enroulement (21), dit d'alimentation, de ce transformateur (20), destiné au transfert d'énergie entre le circuit de découpage (10) et l'étage de sortie du balayage-ligne (30), le second interrupteur (15) comprenant un transistor de commutation (11), dit de découpage, commandé sur sa base à l'aide d'impulsions de retour-ligne recueillies sur un enroulement auxiliaire (25) du transformateur-ligne (20), et une diode (12) montée en anti-parallèle avec celui-ci, le circuit de découpage (10) comprenant, en outre, un quatrième condensateur (13), dit d'accord, formant avec l'inductance de découpage (16) un circuit résonnant, pentant les périodes d'ouverture du second interrupteur (15) travaillant à rapport cyclique constant, obtenues à l'aide d'un signal de commande provoquant le blocage du transistor de découpage (11) et dont les durées sont constantes et supérieures à une demi-période de résonance de ce circuit résonnant (13, 16), la régulation de l'énergie échangée entre le circuit de découpage (10) et l'étage de sortie (30) étant effectuée à l'aide d'un générateur de retard variable en fonction d'une tension ou d'un courant électrique, par la variation du retard entre les instants d'ouverture respectivs du premier (36, 35) et du second (15) interrupteurs, le circuit de découpage (10) comportant, en outre, une bobine de choc (14) insérée entre l'enroulement d'alimentation (21) et l'interrupteur de découpage (15), caractérisé par le fait que cette bobine (14) fait partie intégrante de l'inductance de découpage (16) et, de ce fait, du circuit résonnant comprenant le condensateur d'accord (13) et par le fait que sa valeur est choisie de façon à rendre celle de l'inductance de découpage (16) qui est composée de l'inductance de fuite de l'enroulement d'alimentation (21) et de celle de la bobine (14) en série, sensiblement égale ou supérieur au triple de celle des bobines de déviation (31), ramenée dans le circuit de l'enroulement d'alimentation (21) par le transformateur-ligne (20).

2. Dispositif d'alimentation suivant la revendication 1, du type dans lequel le transistor de découpage (11) est commandé au moyen d'un circuit de régulation (40) comprenant le générateur de retard, caractérisé par le fait que l'entrée du circuit de régulation (40) est alimentée par l'enroulement auxiliaire (25) du transformateur (20) qui lui fournit un signal dont l'une des amplitudes crête est proportionnelle à la tension aux bornes du condensateur d'alimentation (33) de l'étage de sortie (30), rechargé à l'aide du circuit de découpage (10) et dont l'amplitude crête-à-crête est proportionnelle au niveau d'une très-haute-tension fournie par un autre enroulement (23) du transformateur (20), le générateur de retard du circuit de régulation faisant varier le retard de l'instant de blocage du transistor (11) par rapport au front de montée de l'impulsion de retour-ligne engendrée par l'ouverture du premier interrupteur (36, 35).

3. Dispositif d'alimentation suivant la revendication 2, caractérisé par le fait que la régulation par le retard de phase entre les instants de blocage respectifs est effectuée en fonction soit de l'amplitude crête-à-crête, soit de l'amplitude crête pendant le retour ou l'aller du balayage, du signal aux bornes de l'un des enroulements (21 ou 25) du transformateur-ligne (20) en la comparant à une tension de référence et en commandant le retard en fonction de la différence entre la tension correspondant à l'une de ces amplitudes et la tension de référence, afin de stabiliser soit l'amplitude de balayage, c'est-à-dire la tension aux bornes du condensateur d'alimentation (33), soit une tension d'alimentation obtenue par le redressement de l'impulsion de retour-ligne.

4. Dispositif d'alimentation suivant la revendication 2, caractérisé par le fait que le circuit de régulation (40) comporte: un multivibrateur astable (48) dont la sortie est couplée à la base du transistor de découpage (11) à l'aide d'un étage de commande (50) et qui fonctionne au démarrage de façon autonome, et par le fait que le circuit générateur de retard variable comprend un étage déphaseur (46) déclenché par les impulsions de retour-ligne et fournissant au multivibrateur (48) des impulsions de déclenchement retardées par rapport aux fronts de montée des impulsions de retour-ligne, qui provoquent le blocage du transistor de découpage (11), et un étage régulateur (47) fournissant à l'étage déphaseur (46) un signal de régulation permettant de faire varier le retard entre les fronts de montée respectifs des impulsions de retour-ligne et des impulsions de déclenchement en fonction de l'une des amplitudes crête ou de l'amplitude crête-à-crête du signal fourni par l'enroulement auxiliaire (25) du transformateur (20).

5. Dispositif d'alimentation suivant la revendication 4, du type dans lequel le condensateur d'alimentation (33) alimente en tension continue le circuit de balayage-ligne tout entier, caractérisé par le fait que le circuit de régulation (40) est alimenté à l'aide d'une alimentation autonome (51) permettant le démarrage du circuit de découpage (10) par le fonctionnement autonome du multivibrateur astable (48) afin de démarrer l'alimentation du circuit de balayage-ligne par la tension de découpage induite dans le premier enroulement (22) du transformateur (20) et redressée par la diode (35) faisant partie du premier interrupteur bidirectionnel (36, 35), qui charge le condensateur d'alimentation (33).

6. Dispositif d'alimentation suivant l'une des revendication 4 et 5, caractérisé par le fait que l'étage déphaseur (46) comporte un générateur de retard fournissant une tension en forme de dents de scie récurrentes (460, 463) déclenchées par les fronts de montée des impulsions de retour-ligne, à un étage comparateur de tension analogique (469, 4600, 4601) fournissant sur sa sortie des impulsions négatives à la base de celui des transistors (483) du multivibrateur (48) dont le blocage commande le blocage du transistor de découpage (11), et cela à des instants où l'amplitude instantanée des dents de scie dépasse une tension de seuil fixe ($V_{z\ 4601}$), et par le fait que l'étage régulateur (47) comporte un montage redresseur (470, 471) du signal fourni par l'enroulement auxiliaire (25) qui alimente un générateur de signal (476, 475) fournissant un signal qui modifie, à partir d'un seuil prédéterminé, la pente des dents de scie en fonction de l'une des amplitudes crête ou l'amplitude crête-à-crête de ce signal ($v_{25}$).

7. Dispositif d'alimentation suivant la revendication 6, du type dans lequel la fréquence du fonctionnement autonome du multivibrateur astable (48) est inférieure à la fréquence de ligne, caractérisé par le fait que le multivibrateur astable (48) est commandé uniquement par les impulsions négatives issues de l'étage comparateur (469), appliquées à celui des transistors (483) du multivibrateur (48), dont le blocage commande celui du transistor de découpage (11).

8. Dispositif d'alimentation suivant l'une des revendications 4 à 6, du type dans lequel la fréquence du fonctionnement autonome du multivibrateur astable (48) est supérieure à la fréquence de ligne afin de limiter la tension crête ($V_{19\ max}$) sur le collecteur du transistor de découpage (11), caractérisé par le fait que le transistor (480) du multivibrateur (48) dont l'état est complémentaire à celui du transistor de découpage (11), est alimenté sur sa base à travers une diode (4803) par un étage de synchronisation (49) fournissant des impulsions négatives dont l'amplitude est égale à une fraction prédéterminée de celle des impulsions retour-ligne, de façon à prolonger la durée de l'état bloqué de ce transistor (480) initialement plus brève que celle de son état saturé, jusqu'à ce que la somme de ces durées soit égale à la période de ligne.

**Claims**

1. A supply device combined with a line scanning circuit of a television receiver, the output stage (30) of which comprises a first electronic switch (36, 35) of bidirectional type which is periodically controlled to be closed during forward scan and opened during backward scan and which is connected in parallel with a first series circuit composed of line scan coils (31) and a first so-called forward capacitor (32) which feeds said coils (31) during the closure of the first switch (36, 35), with a so-called backward capacitor (34) forming a parallel resonant circuit mainly with the inductance of the coils (31) during the opening of the first switch (36, 35), and with a second series circuit composed of a first winding (22) of a so-called line transformer (20) and a third so-called supply capacitor (33) feeding the first winding (22) with direct voltage during the closure of the first switch (36, 35), the supply device comprising a chopper circuit (10) comprising in series connection between the terminals (6, 7) of a direct voltage supply source (5), a so-called chopper inductance (16) and a second controlled bidirectional electronic switch (15), said chopper inductance (16) comprising a second so-called supply winding (21) of said transformer (20) intended to transfer energy between the chopper circuit (10) and the line scan output stage (30), the second switch (15) comprising a so-called chopper switching transistor (11) controlled at its base by means of line fly-back pulses received in an auxiliary winding (25) of the line transformer (20) and a diode (12) mounted in opposed polarity parallel relationship therewith, the chopper circuit (10) further comprising a fourth so-called tuning capacitor (13) forming a resonant circuit with the chopper inductance (16) during the open periods of the second switch (15) operating at a constant cycle ratio, obtained by means of a control signal causing blocking of the chopper transistor (11) and having constant durations which are longer than a resonance half period of said resonant circuit (13, 16), the regulation of energy exchange between the chopper circuit (10) and the output stage (30) being performed by means of a variable delay generator, with the variable delay depending on an electric voltage or current, by the variation of the delay between the respective opening moments of the first (36, 35) and the second (15) switches, the chopper circuit (10) further comprising a choke coil (14) inserted between the supply winding (21) and the chopper switch (15), characterized by the fact that this coil (14) is an integral part of the chopper inductance (16) and thus of the resonant circuit comprising the tuning capacitor (13), and by the fact that its value is selected to make the value of the chopper inductance (16) composed of the leakage inductance of the supply winding (21) and the inductance of the series coil (14) substantially equal to or greater than three times the inductance of the scanning coils (31) introduced into the circuit of the supply winding (21) by the line transformer (20).

2. Supply device of claim 1, of the type in which the chopper transistor (11) is controlled by a regulating circuit (40) comprising the delay generator, characterized by the fact that the input of the regulating circuit (40) is supplied by the auxiliary winding (25) of the transformer (20) feeding a signal thereto, one of the peak amplitudes of which is proportional to the voltage at the terminals of the supply capacitor (33) of the output stage (30) which is recharged by means of the chopper circuit (10), and the peak-to-peak amplitude of which is proportional to the level of a very high voltage supplied by another winding (23) of the transformer (20), the delay generator of the regulation circuit (40) carrying out the variation the delay of the blocking instant of the transistor (11) with respect to the rising edge of the line fly-back pulse generated by opening of the first switch (36, 35).

3. Supply device of claim 2, characterized by the fact that the regulation by the phase delay between the respective blocking moments is performed as a function either of the peak-to-peak amplitude or the peak amplitude during backward or forward scan of the signal at the terminals of one of the windings (21 or 25) of the line transformer (20) by comparing the same with a reference voltage and controlling the delay as a function of the difference between the voltage corresponding to one of these amplitudes and the reference voltage, in order to stabilize either the scanning voltage, i.e. the voltage at the terminals of the supply capacitor (33), or a supply voltage obtained by rectifying the line fly-back pulse.

4. Supply device of claim 2, characterized by the fact that the regulating circuit (40) comprises: an astable multivibrator (48) the output of which is coupled to the base of the chopper transistor (11) by means of a control stage (50) and which operates in an autonomous manner during starting, and by the fact that the variable delay generator comprises a phase shifting stage (46) triggered by the line fly-back pulses and feeding triggering pulses to the multivibrator (48) which are delayed with respect to the rising edges of the line fly-back pulses and which cause the blocking of the chopper transistor (11), and a regulating stage (47) supplying a regulating signal to the phase shifting stage (46) permitting variation of the delay between the respective rising edges of the line fly-back pulses and the triggering pulses as a function of one of the peak amplitudes or of the peak-to-peak amplitude of the signal supplied by the auxiliary winding (25) of the transformer (20).

5. Supply device of claim 4, of the type in which the supply capacitor (33) feeds the entire line scanning circuit with direct voltage, characterized by the fact that the regulating circuit (40) is supplied by means of an autonomous supply (51) allowing the starting of the chopper circuit (10) by the autonomous operation of the astable multivibrator (48) to start the supply of the scanning circuit by the chopper voltage induced in the first winding (22) of the transformer (20) and rectified by the diode (35) forming part of the first bidirectional switch (36, 35) which charges the supply capacitor (33).

6. Supply device of one of claims 4 and 5, characterized by the fact that the phase shifting stage (46) comprises a delay generator delivering a saw tooth voltage with recurring teeth (460, 463) triggered by the rising edges of the line fly-back pulses to an analogous voltage comparator stage (469, 4600, 4601) supplying negative pulses at its output to the base of that one of transistors (483) of the multivibrator (48) the blocking of which controls the blocking of the chopper transistor (11), which occurs at the instants where the momentary amplitude of the saw teeth exceeds a fixed threshold voltage

($V_{Z\,4601}$), and by the fact that the regulating stage (47) comprises a rectifying circuit (470, 471) for rectifying the signal supplied by the auxiliary winding (25) supplying a signal generator (476, 475) delivering a signal which, starting from a predetermined threshold, modifies the inclination of the saw teeth as a function of one of the peak amplitudes or the peak-to-peak amplitude of this signal ($v_{25}$).

7. Supply device of claim 6, of the type in which the frequency of the autonomous operation of the astable multivibrator (48) is lower than the line frequency, characterized by the fact that the astable multivibrator (48) is controlled only by the negative pulses delivered from the comparator stage (469) and applied to that one of the transistors (483) of the multivibrator (48) the blocking of which controls the blocking of the chopper transistor (11).

8. Supply device of one of claims 4 through 6, of the type in which the frequency of autonomous operation of the astable multivibrator (48) is higher than the line frequency in order to limit the peak voltage ($V_{19\,max}$) at the collector of the chopper transistor (11), characterized by the fact that the transistor (480) of the multivibrator (48) the condition of which is complementary to the condition of the chopper transistor (11) is supplied at its base through a diode (4803) by a synchronization stage (49) delivering negative pulses the amplitude of which is a predetermined fraction of the amplitude of the line flyback pulses so as to extend the duration of the blocked condition of this transistor (480) which is intially shorter than the duration of its saturated condition until the sum of these durations is equal to the line period.

**Patentansprüche**

1. Speisevorrichtung, die mit einer Zeilen-Ablenkschaltung eines Fernsehempfängers kombiniert ist, dessen Ausgangsstufe (30) einen ersten elektronischen Unterbrecher (36, 35) vom bidirektionalen Typ enthält, der periodisch so gesteuert ist, daß er während des Ablenkhinlaufs geschlossen und während des Ablenk-Rücklaufs geöffnet ist, und der parallelgeschaltet ist zu einer ersten Reihenschaltung, die zusammengesetzt ist aus Zeilen-Ablenkspulen (31) und einem ersten, als Hinlaufkondensator bezeichneten Kondensator (32), der diese Spulen (31) während des Schließens des ersten Unterbrechers (36, 35) speist, zu einem zweiten Kondensator (34), der als Rücklaufkondensator bezeichnet wird und während des Öffnens des ersten Unterbrechers (36, 35) einen Parallelresonanzkreis hauptsächlich mit der Induktivität der Spulen (31) bildet, und zu einer zweiten Reihenschaltung, die zusammengesetzt ist aus einer ersten Wicklung (22) eines als Zeilentransformator bezeichneten Transformators (20) und einem dritten Konsensator (33), der als Speisekondensator bezeichnet wird und die erste Wicklung (22) während des Schließens des ersten Unterbrechers (36, 35) mit Gleichspannung speist, wobei die Speisevorrichtung eine Zerhackerschaltung (10) enthält, die in Reihe zwischen die Anschlüsse (6, 7) einer Versorgungsgleichspannungsquelle (5) geschaltet eine als Zerhackerinduktivität bezeichnete Induktivität (16) und einen zweiten elektronischen, gesteuerten bidirektionalen Unterbrecher (15) aufweist, wobei diese Zerhackerinduktivität (16) eine zweite, als Speisewicklung bezeichnete Wicklung (21) dieses Transformators (20) umfaßt, die zur Energieübertragung zwischen der Zerhackerschaltung (10) und der Ausgangsstufe (30) der Zeilenablenkung bestimmt ist, wobei der zweite Unterbrecher (15) einen Schalttransistor (11) umfaßt, der als Zerhackertransistor bezeichnet wird und an seiner Basis von Zeilenrücklaufimpulsen gesteuert ist, die an einer Hilfswicklung (25) des Zeilentransformators (20) abgegriffen werden, sowie eine Diode (12) umfaßt, die antiparallel zu ihm geschaltet ist, wobei die Zerhackerschaltung (10) ferner einen vierten Kondensator (13) umfaßt, der als Abgleichkondensator bezeichnet wird und mit der Zerhackerinduktivität (16) einen Resonanzkreis während der Öffnungsperioden des zweiten Unterbrechers (15) bildet, der mit einem konstanten zyklischen Verhältnis arbeitet, welche mittels eines Steuersignals erhalten werden, das die Sperrung des Zerhackertransistors (11) hervorruft und dessen Dauer jeweils konstant und länger als eine Resonanz-Halbperiode dieses Resonanzkreises (13, 16) ist, wobei die Regulierung der zwischen der Zerhackerschaltung (10) und der Ausgangsstufe (30) ausgetauschten Energie mittels einer Einrichtung, die eine in Abhängigkeit von einer elektrischen Spannung oder einem elektrischen Strom veränderliche Verzögerung erzeugt, durch die Änderung der Verzögerung zwischen den jeweiligen Zeitpunkten des Öffnens des ersten Unterbrechers (36, 35) und des zweiten Unterbrechers (15) erfolgt, und wobei ferner die Zerhackerschaltung (10) eine Drosselspule (14) umfaßt, die zwischen die Speisewicklung (21) und den Zerhackerunterbrecher (15) eingefügt ist, dadurch gekennzeichnet, daß diese Spule (14) einen integrierenden Bestandteil der Zerhackerinduktivität (16) und somit des Resonanzkreises bildet, welcher den Abstimmkondensator (13) enthält, udn daß ihr Wert so gewählt ist, daß der Wert der Zerhackerinduktivität (16), die aus der Streuinduktivität der Speisewicklung (21) und derjenigen der Spule (14) in Reihe miteinander gebildet ist, im wesentlichen gleich dem Dreifachen des Wertes der Ablenkspulen (31) oder größer als dieser ist, der durch den Zeilentransformator (20) in den Kreis der Speisewicklung (21) zurückgeführt wird.

2. Speisevorrichtung nach Anspruch 1, des Typs, bei welchem der Zerhackertransistor (11) mittels einer Regelschaltung (40) gesteuert ist, welche die die Verzögerung erzeugende Einrichtung enthält, dadurch gekennzeichnet, daß der Eingang der Regelschaltung (40) von der Hilfswicklung (25) des Transformators (20) gespeist ist, die ihr ein Signal zuführt, dessen eine Spitzenwertamplitude proportional zu der Spannung an den Anschlüssen des Speisekondensators (33) der Ausgangsstufe (30) ist, welcher mittels der Zerhackerschaltung (10) wieder aufgeladen wird, und dessen Amplitude von Spitzenwert zu Spitzenwert proportional dem Pegel einer sehr hohen Spannung ist, die von einer anderen Wicklung (23) des Transformators (20) geliefert wird, wobei die Verzögerungseinrichtung der Regelschaltung (40) die Verzögerung des Sperrzeitpunktes des Transistors (11) in bezug auf die Anstiegsflanke des Zeilenrücklaufimpulses, der durch Öffnung des ersten Unterbrechers (36, 35) erzeugt wird.

3. Speisevorrichtung nach Anspruch 2, dadurch gekennzeichnet, daß die Regulierung durch die Phasenverzögerung zwischen den jeweiligen Sperrzeitpunkten in Abhängigkeit entweder von der Amplitude von Spitzenwert zu Spitzenwert oder von der Spitzenwertamplitude während des Ablenkrück- oder -hinlaufs, die das Signal an den Anschlüssen einer der Wicklungen (21 oder 25) des Zeilentransformators (20) aufweist, und durch Vergleichen derselben mit einer Bezugsspannung sowie durch Steuerung der Verzögerung in Abhängigkeit von der Differenz zwischen der einer dieser Amplituden entsprechenden Spannung und der Bezugsspannung erfolgt, um entweder die Ablenkamplitude, d.h. die Spannung an den Anschlüssen des Speisekondensators (33) oder eine Speisespannung zu stabilisieren, die durch Gleichrichtung des Zeilenrücklaufimpulses erhalten wird.

4. Speisevorrichtung nach Anspruch 2, dadurch gekennzeichnet, daß die Regelschaltung (40) enthält: einen astabilen Multivibrator (48), dessen Ausgang an die Basis des Zerhackertransistors (11) über eine Steuerstufe (50) angekoppelt ist und welcher beim Anlaufen selbsttätig arbeitet, und daß die Schaltung zur Erzeugung der variablen Verzögerung eine Phasenshieberstufe (46) umfaßt, die durch die Zeilenrücklaufimpulse ausgelöst wird und dem Multivibrator (48) Auslöseimpulse liefert, die in bezug auf die Anstiegsflanken der Zeilenrücklaufimpulse verzögert sind, welche die Sperrung des Zerhackertransistors (11) verursachen, und eine Regelstufe (47) aufweist, welche der Phasenschieberstufe (46) ein Regelsignal zuführt, welches es ermöglicht, die Verzögerung zwischen den jeweiligen Anstiegsflanken der Zeilenrücklaufimpulse und der Auslöseimpulse in Abhängigkeit von einer der Spitzenwertamplituden oder der Amplitude von Spitzenwert zu Spitzenwert des Signals, welches von der Hilfswicklung (25) des Transformators (20) geliefert wird, zu verändern.

5. Speisevorrichtung nach Anspruch 4, des Typs, bei welchem der Speisekondensator (33) die gesamte Zeilenablenkschaltung mit Gleichspannung versorgt, dadurch gekennzeichnet, daß die Regelschaltung (40) durch eine unabhängige Versorgung (51) gespeist ist, die das Anlaufen der Zerhackerschaltung (10) durch selbsttätigen Betrieb des astabilen Multivibrators (48) ermöglicht, um die Speisung der Zeilenablenkschaltung durch die Zerhackerspannung auszulösen, die in der ersten Wicklung (22) des Transformators (20) induziert wird und von der Diode (35) gleichgerichtet wird, die einen Bestandteil des ersten bidirektionalen Unterbrechers (36, 35) bildet, welche den Speisekondensator (33) auflädt.

6. Speisevorrichtung nach Anspruch 4 oder 5, dadurch gekennzeichnet, daß die Phasenschieberstufe (46) einen Verzögerungsgenerator enthält, der eine Sägezahnspannung liefert, deren sich wiederholende Sägezahnschwingungen (460, 463) durch die Anstiegsflanken der Zeilenrücklaufimpulse ausgelöst werden, wobei diese Sägezahnspannung einer analogen Spannungsvergleicherstufe (469, 4600, 4601) zugeführt wird, die an ihrem Ausgang negative Impulse an die Basis desjenigen Transistors (483) des Multivibrators (48) anlegt, dessen Sperrung die Sperrung des Zerhackertransistors (11) steuert, und zwar zu Zeitpunkten, wo die Augenblicksamplitude der Sägezahnschwingungen eine feste Schwellspannung ($V_{Z\,4601}$) überschreitet, und daß die Regelstufe (47) eine Gleichrichterschaltung (470, 471) zur Gleichrichtung des durch die Hilfswicklung (25) gelieferten Signals umfaßt, die einen Signalgenerator (476, 475) speist, der ein Signal liefert, welches ausgehend von einem vorbestimmten Schwellwert die Neigung der Sägezahnschwingungen in Abhängigkeit von einer der Spitzenwertamplituden oder der Amplitude von Spitzenwert zu Spitzenwert dieses Signals ($v_{25}$) verändert.

7. Speisevorrichtung nach Anspruch 6, des Typs, bei welchem die Frequenz des selbständigen Betriebs des astabilen Multivibrators (48) niedriger als die Zeilenfrequenz ist, dadurch gekennzeichnet, daß der astabile Multivibrator (48) allein durch die negativen Impulse gesteuert wird, die von der Vergleicherschaltung (469) abgegeben werden und an denjenigen Transistor (483) des Multivibrators (48) angelegt sind, dessen Sperrung diejenige des Zerhackertransistors (11) steuert.

8. Speisevorrichtung nach einem der Ansprüche 4 bis 6, des Typs, bei welchem die Frequenz des selbständigen Betriebs des astabilen Multivibrators (48) höher als die Zeilenfrequenz ist, um die Spitzenwertspannung ($V_{19\,max}$) am Kollektor des Zerhackertransistors (11) zu begrenzen, dadurch gekennzeichnet, daß derjenige Transistor (480) des Multivibrators (48), dessen Zustand komplementär zu demjenigen des Zerhackertransistors (11) ist, an seiner Basis über eine Diode (4803) durch eine Synchronisationsstufe (49) gespeist wird, welche negative Impulse liefert, deren Ampli-

39     0 005 391     40

tude gleich einem vorbestimmten Bruchteil der Amplitude der Zeilenrücklaufimpulse ist, so daß die Dauer des Sperrzustands dieses Transistors (480) verlängert wird, die anfangs kürzer ist als die Dauer seines gesättigten Zustands, bis die Summe dieser Dauern gleich der Zeilenperiode ist.

0 005 391

FIG_1

FIG_5

0 005 391

# FIG_2

FIG_2-a

FIG_2-b

FIG_2-c

FIG_2-d

FIG_2-e

FIG_2-f

$T_H = 64 \mu s$

$t_A \cong 52 \mu s$

$t_R \cong 12 \mu s$

$V_{221}$

$V_{221} \, n_{21}/n_{22}$

$T_H/4$

$\pi \sqrt{L_{16} \cdot C_{13}}$

$V_A$

$i_{16} \, (i_{21})$

$i_{21}$

$i_{16}$

$E_i = V_{21} \cdot i_{21}$

$T_H$

0 005 391

FIG_3

FIG_3-a

FIG_3-b

FIG_3-c

FIG_3-d

FIG_3-e

FIG_3-f

3

# FIG_4

FIG_6

# FIG_7

FIG_7-a

$T_H = 64 \mu S$

$V_{Z491}$

$V_{25}$

$V_{25} - V_{Z491}$

FIG_7-b

$V_{BES}$

$T_A = 58 \mu S$

$t_{SA}$

$t_B$

$V_R - V_{BES}$

$T_H$

$t_{SA}$

$\Delta t_S$

$T_B$

$\Delta t_S$

$$\frac{R_{494}(V_{25} - V_Z)}{R_{492} + R_{494}}$$

# FIG_8

FIG.8-a

$V_{25}$

$V_{25B}$

$V_{25F}$

$V_{25N}$

$T_H$

FIG.8-b

$V_{460}$

$T_B$

$T_F$

$T_N$

$V_Z + V_{BEm}$

$t_1$ $t_2$ $t_3$ $t_4$ $t_5$ $t_6$ $t_7$

FIG.8-C

$V_{469}$

$V_R$

$t_{RB}$ $t_{RF}$ $t_{RN}$

0 005 391